# FASCICULE DE BREVET EUROPEEN

(11) **EP 4 460 649 B1**
(45) Date de publication et mention de la délivrance du brevet: **12.11.2025**
(21) Numéro de dépôt: 23701625.8
(22) Date de dépôt: 05.01.2023
(51) Int. Cl.: F16K 1/34, F16K 31/00, H02N 2/18

(54) **VALVE COMPORTANT UN ACTIONNEUR PIÉZOÉLECTRIQUE**
VENTIL MIT EINEM PIEZOELEKTRISCHEN AKTUATOR
VALVE WITH A PIEZOELECTRIC ACTUATOR

(30) Priorité: 06.01.2022 FR 2200092
(43) Date de publication de la demande: 13.11.2024
(73) Titulaire: Pytheas Technology, 13600 La Ciotat (FR)
(72) Inventeur: MOSCA, Frédéric, 13600 La Ciotat (FR); GROSSO, Gilles, 13600 La Ciotat (FR); CLEMENT, Simon, 13600 La Ciotat (FR); AUBRY, Alice, 13600 La Ciotat (FR)
(74) Mandataire: Roman, Alexis
(86) Numéro de dépôt international: PCT/EP2023/050199
(87) Numéro de publication internationale: WO 2023/131660

(56) Documents cités:
- PL-Y1- 70 208
- US-A- 3 166 684
- US-A- 3 350 583
- US-A1- 2013 048 898
- US-A1- 2017 211 716

## Description

### Domaine technique.

La présente invention a pour objets une valve comportant un actionneur piézoélectrique et un procédé pour accélérer l'ouverture/fermeture d'une telle valve. L'invention a encore pour objet un système de génération d'électricité comportant une telle valve.

L'invention concerne le domaine technique des valves utilisant un actionneur piézoélectrique pour commander leur ouverture/fermeture et plus spécifiquement, mais non exclusivement le domaine des valves ultra-rapides (temps d'ouverture/fermeture égal ou inférieur à 1,5 ms).

### État de la technique.

Dans la suite, l'invention est illustrée principalement en lien avec un fluide hydraulique, mais bien entendu l'invention n'est pas limitée à cette application et peut être utilisée avec un fluide gazeux.

L'hydraulique est utilisé dans beaucoup de domaines grâce à sa densité de puissance (puissance par unité de volume) très élevée. On observe par exemple son utilisation fréquente dans des dispositifs tels que les engins de levage, les éoliennes, ou encore dans des domaines de précisions comme l'aéronautique, les drones ou les engins spatiaux.

Les valves sont généralement utilisées pour alimenter ou non plusieurs actionneurs intégrés dans ces dispositifs à puissance nominale, en bloquant ou en laissant passer du fluide. Des valves ultra-rapides sont particulièrement avantageuses pour alimenter ou non ces actionneurs à haute fréquence, en fonction de la puissance voulue. En effet, plus le temps de réponse de la valve est faible, plus la précision du système global sera importante et plus le nombre d'actionneurs utilisés pourra être important, faisant ainsi gagner en efficacité énergétique.

L'art antérieur fait état d'un grand nombre de valves qui se divisent essentiellement en deux grandes familles : les valves à commande hydraulique et les valves à commande électrique.

Les valves à commande hydraulique s'ouvrent et se ferment en répondant à une commande de pression (dans un circuit secondaire). Ces valves ont un temps de réponse minimum de 1,5 ms à 2 ms pour les meilleures, mais sont encombrantes à cause de leurs multiples étages et nécessitent une alimentation en fluide haute pression constante.

Les valves à commande électrique s'ouvrent et se ferment en répondant à une commande électrique. Ces valves ont un temps de réponse minimum de 3 ms à 4 ms pour les meilleures. Ce type de valve permet un contrôle plus direct, notamment en utilisant des signaux électriques qui commandent des actionneurs électromagnétiques (type solénoïde). Leur temps de réponse est toutefois assez important principalement dû à l'inertie des bobinages utilisés. En outre, la densité force fournie par ces actionneurs électromagnétiques est généralement faible (dépendant de la taille des bobinages).

L'intégration d'actionneur piézoélectrique dans une valve à commande électrique permet d'augmenter ses performances, non seulement en termes de temps de réponse, mais également en termes de densité de force. Toutefois, le déplacement d'un actionneur piézoélectrique est généralement faible (quelques dizaines de microns), de sorte que le débit de fluide susceptible de traverser la valve est faible.

Pour remédier à cela, des valves dites « à plaques de Hörbiger » ont été développées, notamment par l'Université de Bath (ci-après nommée « valve Bath ») et décrites dans les publications suivantes :
David T. Branson et al. "Dynamic simulation model of hydraulic valve utilising the Hörbiger plate principal and piezoactuation to achieve high bandwidth and flow performance". Proceedings of the IMECE2008-67401, 2008 AMCE.
David. T. Branson et al. "Piezoelectrically actuated hydraulic valve design for high bandwidth and flow performance". Proceedings of the Institution of Mechanical Engineers, Part I: Journal of Systems and Control Engineering, 2011, pp. 225-345.

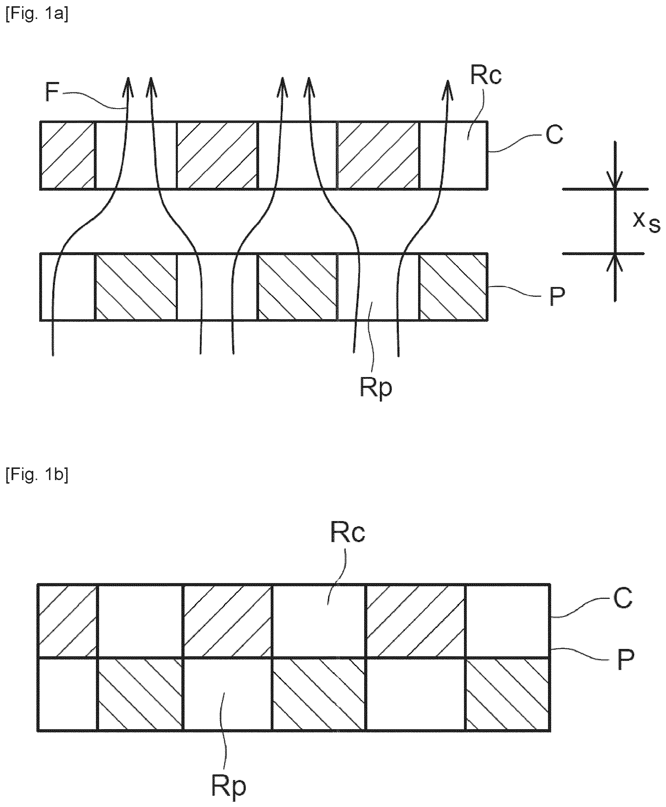

La valve Bath comprend une plaque fixe P et un clapet mobile C opposé à ladite plaque. Le principe est basé des canaux de passage de fluide se présentant sous la forme de rainures annulaires Rp, Rc aménagées dans la plaque et le clapet. Comme illustré sur la figure 1a, lorsque le clapet C est espacé de la plaque P, le fluide F passe au travers des canaux Rp, Rc, dont la configuration en rainures annulaires augmente considérablement la surface d'écoulement globale par rapport aux configurations traditionnelles de valve. Il est ainsi possible d'obtenir des débits élevés même avec un faible déplacement xₛ du clapet C (de quelques dizaines de microns). Les débits de fluide susceptibles de passer au travers de la valve sont d'environ 65 L/min à 20 bars (2 MPa) avec des temps d'ouverture/fermeture inférieurs à 1,5 ms. En position de fermeture (figure 1b), le clapet C est en contact avec la plaque P de sorte que les canaux Rp, Rc ne sont plus en communication fluidique.

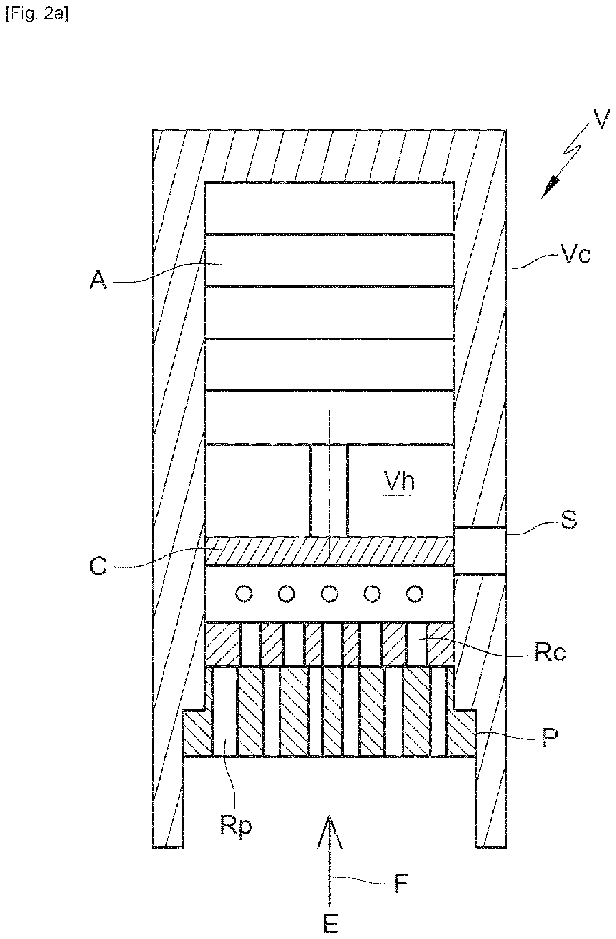

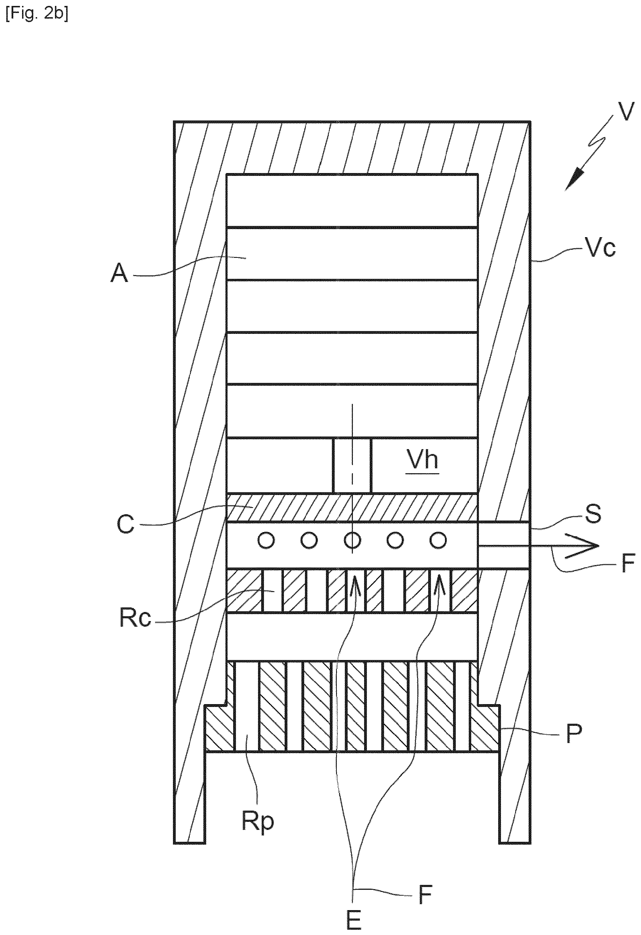

En se rapportant aux figures 2a et 2b, la valve Bath comprend une entrée E de fluide sous pression et une sortie S de fluide. En position d'ouverture (figure 2b), le clapet C est espacé de la plaque fixe P de sorte que le fluide s'écoule depuis l'entrée E, vers la sortie S, en passant au travers des canaux Rc, Rp. Un actionneur piézoélectrique A est disposé dans une première chambre Vh et agit sur une face active du clapet C de manière à le déplacer entre la position de fermeture (figure 2a) et la position d'ouverture (figure 2b). L'entrée E (haute pression) est disposée en amont de la plaque P et est connectée fluidiquement aux canaux Rp de la plaque P. La sortie S (basse pression) est connectée fluidiquement aux canaux Rc du clapet C de sorte qu'en usage, en position d'ouverture, le fluide F circule des canaux Rp de la plaque P vers les canaux Rc du clapet C.

La valve Bath est intéressante, mais présente quelques limites. En premier lieu, la pression maximale d'utilisation réelle (et non pas simulée) est de l'ordre de 10 bars à 20 bars, de sérieux problèmes de fuite apparaissant au-delà de ces pressions. Le champ d'application de la valve Bath est donc limité. En second lieu, si les temps d'ouverture/fermeture sont faibles (de 1 ms à 1,5 ms), ils restent du même ordre de grandeur que les valves à commande hydraulique du marché les plus performantes. Pour ces raisons, il n'y a pas vraiment d'intérêt pratique à utiliser une valve Bath dans un dispositif industriel.

On connait également par les documents brevets US2013/0048898 et US2017/0211716 d'autres valves à actionneur piézoélectrique. Dans le document US2013/0048898, un ressort à lame est en prise avec le clapet pour le solliciter vers la position de fermeture ou d'ouverture selon le mode de réalisation retenue. De par cette conception, lorsque la valve est soumise à des hautes pressions de fluide, ses temps d'ouverture/fermeture sont relativement lents, notamment du fait de la force de pression exercée sur la face active du clapet. Il en est de même pour la valve décrite dans le document US2017/0211716, dans la mesure où l'effort de pression exercé sur la face active du clapet vient freiner le déplacement du clapet vers la position d'ouverture ou de fermeture.

L'invention vise à remédier à tout ou partie des inconvénients précités. En particulier, la présente invention entend proposer une valve dont la conception est basée sur le principe de la valve Bath (valve type à plaque de Hörbiger a actionneur piézoélectrique) qui, dans des conditions réelles d'utilisation (et non pas seulement dans des conditions simulées) soit capable de fonctionner à des pressions nettement supérieures à 20 bars, pouvant aller jusqu'à plusieurs centaines de bars. Un autre objectif de l'invention est de proposer une valve dont les temps d'ouverture/fermeture sont réduits par rapport aux valves de l'art antérieur, notamment lorsque ladite valve est soumise à des hautes pressions de fluide (≥ 100 bars).

### Présentation de l'invention.

La solution proposée par l'invention est une valve comprenant une entrée de fluide sous pression et une sortie de fluide, laquelle valve comporte :
- une plaque fixe dans laquelle sont aménagés des premiers canaux de passage de fluide,
- un clapet dans lequel sont aménagés des seconds canaux de passage de fluide, ledit clapet étant monté mobile entre : - une position d'ouverture dans laquelle les premiers canaux et les seconds canaux sont dans une configuration autorisant le passage du fluide entre l'entrée et la sortie ; - et une position de fermeture dans laquelle les premiers canaux et les seconds canaux sont dans une configuration bloquant le passage du fluide entre l'entrée et la sortie, laquelle entrée est aménagée de sorte qu'en usage, le fluide sous pression exerce une force de pression sur une face active dudit clapet contraignant ledit clapet vers la position de fermeture
- un actionneur piézoélectrique agissant sur le clapet pour le déplacer entre la position de fermeture et la position d'ouverture, lequel actionneur consiste en un pilier piézoélectrique formé par une structure d'empilement d'éléments piézoélectriques, lequel pilier s'allonge lorsque l'actionneur est mis sous tension et se rétracte lorsque ledit actionneur n'est pas sous tension.

Le fonctionnement de la valve objet de l'invention est inversé par rapport à la valve Bath. Le fluide sous pression agit maintenant sur le clapet mobile dans le sens de la fermeture alors que dans la valve Bath, la pression du fluide agit sur le clapet mobile dans le sens de l'ouverture. En d'autres termes, dans l'invention, la position de la haute pression se trouve en amont du clapet mobile et agit mécaniquement dans le sens de l'actionneur piézoélectrique lors de la phase de fermeture, contribuant ainsi à améliorer l'étanchéité de la valve. Ainsi, plus la pression du fluide augmente, meilleure est l'étanchéité, de sorte que la valve peut maintenant fonctionner à des pressions supérieures à 100 bars et pouvant aller jusqu'à plusieurs centaines de bars.

Selon un mode de réalisation, l'actionneur est en outre précontraint axialement au moyen d'une ou plusieurs tiges de précontrainte formant des éléments ressort dont la force de rappel agit dans le sens de la rétractation du pilier piézoélectrique.

Ces tiges de précontrainte permettent de décupler la vitesse de rétractation du pilier piézoélectrique. La demanderesse a pu constater que les temps d'ouverture et de fermetures étaient de l'ordre de 0,5 ms, ce qui est nettement plus rapide que les valves de l'art antérieur.

En outre, de par sa conception relativement simple et ses performances réelles, la valve objet de l'invention est industriellement exploitable, avec des coûts de fabrication réduits.

D'autres caractéristiques avantageuses de la valve objet de l'invention sont listées ci-dessous. Chacune de ces caractéristiques peut être considérée seule ou en combinaison avec les caractéristiques définies ci-dessus. Chacune de ces caractéristiques contribue, le cas échéant, à la résolution de problèmes techniques spécifiques définis plus avant dans la description et auxquels ne participent pas nécessairement les caractéristiques remarquables définies ci-dessus. Ces dernières peuvent faire l'objet, le cas échéant, d'une ou plusieurs demandes de brevet divisionnaires :

Selon un mode de réalisation permettant d'obtenir les meilleurs résultats en termes de rapidité d'ouverture/fermeture, la force de précontrainte appliquée par la ou les tiges de précontrainte sur le pilier piézoélectrique est comprise entre 5% et 20% de la force mécanique délivrée par ledit pilier piézoélectrique seul (c.-à-d. sans précontrainte) et/ou la ou les tiges de précontrainte présentent une raideur comprise entre 10% et 20% de la raideur du pilier piézoélectrique seul.

Selon un mode de réalisation, en position d'ouverture, le clapet est espacé de la plaque de sorte que les premiers canaux et les seconds canaux sont en communication fluidique. Et en position de fermeture, le clapet est en contact avec la plaque de sorte que les premiers canaux et les seconds canaux ne sont pas en communication fluidique.

Selon un mode de réalisation : - le clapet est monté mobile dans une chambre entre la position d'ouverture et la position de fermeture ; - les seconds canaux sont en communication fluidique avec la chambre ; - l'entrée est disposée en amont du clapet, au niveau de la chambre ; - la sortie est disposée en aval de la plaque, en communication fluidique avec les premiers canaux de sorte qu'en usage et en position d'ouverture, le fluide circule des seconds canaux vers lesdits premiers canaux.

Selon un mode de réalisation, l'actionneur piézoélectrique est configuré de sorte que le clapet soit naturellement en position d'ouverture lorsque ledit actionneur n'est pas sous tension, la ou les tiges de précontrainte étant configurées de sorte que la force de rappel exercée par ladite ou lesdites tiges agisse contre la force de pression qui s'exerce, en usage, sur la face active dudit clapet lorsque ledit clapet passe de la position de fermeture à la position d'ouverture.

Selon un mode de réalisation, l'actionneur piézoélectrique est configuré de sorte que le clapet soit naturellement en position de fermeture lorsque ledit actionneur n'est pas sous tension, la ou les tiges de précontrainte étant configurées de sorte que la force de rappel exercée par ladite ou lesdites tiges se combine à la force de pression qui s'exerce, en usage, sur la face active dudit clapet lorsque ledit clapet passe de la position d'ouverture à la position de fermeture

Selon un mode de réalisation, le clapet est disposé entre l'actionneur et la plaque.

Selon un mode de réalisation, la plaque est disposée entre l'actionneur et le clapet.

Selon un mode de réalisation : - les éléments piézoélectriques de l'actionneur sont montés sur une tige précontrainte installée selon un axe de translation ; - la tige est en prise avec le clapet de sorte qu'une translation de ladite tige induite par l'actionneur piézoélectrique entraîne la translation dudit clapet entre les positions d'ouverture et de fermeture.

Selon un mode de réalisation, la plaque présente un orifice central dans lequel se loge la tige, ledit orifice faisant office de guidage de ladite tige.

Selon un mode de réalisation : - l'actionneur piézoélectrique présente, au niveau de l'une de ses extrémités, une pièce de liaison sur laquelle vient se fixer le clapet ; - le clapet comporte, au niveau d'une face, un élément en saillie adapté pour se fixer sur la pièce de liaison.

Selon un mode de réalisation : - le clapet comporte, au niveau d'une autre face, un autre élément en saillie se prolongeant vers la plaque ; - la plaque présente un orifice central dans lequel se loge ledit autre élément en saillie, ledit orifice faisant office de guidage dudit autre élément en saillie.

Un autre aspect de l'invention concerne un système de génération d'électricité comportant :
- un circuit dans lequel circule un fluide sous pression,
- au moins une cavité fluidique aménagée sur au moins une portion du circuit, laquelle cavité loge un générateur piézoélectrique relié à un circuit électronique d'extraction de charges apte à récupérer l'énergie électrique provenant dudit générateur piézoélectrique,
et dans lequel :
- la cavité fluidique est installée entre deux valves conformes à l'une des caractéristiques précédentes, respectivement une valve d'admission et une valve d'échappement,
- dans une première séquence de fonctionnement, la valve d'admission est pilotée pour que son clapet soit en position d'ouverture et la valve d'échappement est pilotée pour que son clapet soit en position de fermeture, de sorte que le fluide sous pression pénètre et rempli au moins partiellement la cavité fluidique de manière à engendrer une pression mécanique sur le générateur piézoélectrique, laquelle pression entraîne une déformation dudit générateur générant une énergie électrique récupérée par le circuit électronique d'extraction de charges,
- dans une deuxième séquence de fonctionnement, la valve d'admission est pilotée pour que son clapet soit en position de fermeture et la valve d'échappement est pilotée pour que son clapet soit en position d'ouverture, de sorte que le fluide sous pression s'échappe de la cavité fluidique et que le générateur piézoélectrique ne soit plus contraint.

Selon un mode de réalisation, la fréquence d'ouverture/fermeture des valves d'admission et d'échappement, est commandée de sorte qu'elle corresponde à la fréquence de résonnance du générateur piézoélectrique.

Selon un mode de réalisation, la valve d'admission est telle que le clapet est disposé entre l'actionneur et la plaque. Et la valve d'échappement est telle que la plaque est disposée entre l'actionneur et le clapet.

Encore un autre aspect de l'invention concerne un procédé pour accélérer l'ouverture/fermeture d'une valve, laquelle valve comprend une entrée de fluide sous pression et une sortie de fluide, et comporte :
- une plaque fixe dans laquelle sont aménagés des premiers canaux de passage de fluide,
- un clapet dans lequel sont aménagés des seconds canaux de passage de fluide, ledit clapet étant monté mobile entre : - une position d'ouverture dans laquelle les premiers canaux et les seconds canaux sont dans une configuration autorisant le passage du fluide entre l'entrée et la sortie ; - une position de fermeture dans laquelle les premiers canaux et les seconds canaux sont dans une configuration bloquant le passage du fluide entre l'entrée et la sortie,
- un actionneur piézoélectrique agissant sur le clapet pour le déplacer entre la position de fermeture et la position d'ouverture, lequel actionneur consiste en un pilier piézoélectrique formé par une structure d'empilement d'éléments piézoélectriques, lequel pilier s'allonge lorsque l'actionneur est mis sous tension et se rétracte lorsque ledit actionneur n'est pas sous tension.

Ce procédé est remarquable en ce qu'il comprend les étapes consistant à :
aménager l'entrée de sorte qu'en usage, le fluide sous pression exerce une force sur une face active du clapet contraignant ledit clapet vers la position de fermeture ; et précontraindre axialement l'actionneur au moyen d'une ou
plusieurs tiges de précontrainte formant des éléments ressort dont la force de rappel agit dans le sens de la rétractation du pilier piézoélectrique.

### Brève description des figures.

D'autres avantages et caractéristiques de l'invention apparaîtront mieux à la lecture de la description d'un mode de réalisation préféré qui va suivre, en référence aux dessins annexés, réalisés à titre d'exemples indicatifs et non limitatifs et sur lesquels :
[Fig. 1a] précitée illustre le principe de fonctionnement d'une valve type à plaque de Hörbiger, le clapet étant en position d'ouverture.
[Fig. 1b] précitée illustre le principe de fonctionnement d'une valve type à plaque de Hörbiger, le clapet étant en position de fermeture.
[Fig. 2a] précitée est une vue en coupe schématique d'une valve Bath de l'art antérieur, le clapet étant en position de fermeture.
[Fig. 2b] précitée est une vue en coupe schématique d'une valve Bath de l'art antérieur, le clapet étant en position d'ouverture.
[Fig. 3] est une représentation schématique montrant l'agencement d'une valve selon l'invention dans une installation.
[Fig. 4a] est une vue en coupe schématique d'une valve selon un premier mode de réalisation de l'invention, le clapet étant en position d'ouverture.
[Fig. 4b] est une vue en coupe schématique de la valve de la figure 4a, le clapet étant en position de fermeture.
[Fig. 5a] est une vue en coupe schématique d'une valve selon un deuxième mode de réalisation de l'invention, le clapet étant en position d'ouverture.
[Fig. 5b] est une vue en coupe schématique de la valve de la figure 5a, le clapet étant en position de fermeture.
[Fig. 6a] est une vue en coupe schématique d'une valve selon un troisième mode de réalisation de l'invention, le clapet étant en position d'ouverture.
[Fig. 6b] est une vue en coupe schématique de la valve de la figure 6a, le clapet étant en position de fermeture.
[Fig. 7a] est une vue en coupe schématique d'une valve selon un quatrième mode de réalisation de l'invention, le clapet étant en position d'ouverture.
[Fig. 7b] est une vue en coupe schématique de la valve de la figure 7a, le clapet étant en position de fermeture.
[Fig. 8] est une vue en coupe selon A-A de la plaque illustrée sur la figure 4a.
[Fig. 9] est une vue en coupe selon B-B du clapet illustré sur la figure 4a.
[Fig. 10] est une représentation schématique montrant l'agencement d'un générateur piézoélectrique dans un système selon l'invention.
[Fig. 11] est une représentation schématique montrant l'agencement de plusieurs générateurs piézoélectriques dans un système selon l'invention.

### Description des modes de réalisation.

Tel qu'utilisé ici, et sauf indication contraire, l'utilisation des adjectifs ordinaux « premier », « deuxième », etc., pour décrire un objet indique simplement que différentes occurrences d'objets similaires sont mentionnées et n'implique pas que les objets ainsi décrits doivent être dans une séquence donnée, que ce soit dans le temps, dans l'espace, dans un classement, etc. Les adverbes « amont » et « aval » sont employés relativement à l'écoulement du fluide dans la valve et/ou le circuit hydraulique dans lequel la valve est installée.

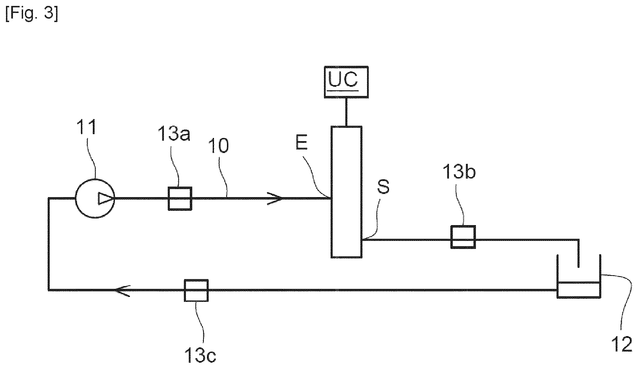

En se rapportant à la figure 3, la valve V objet de l'invention est principalement destinée à être intégrée dans un conduit 10 pour autoriser ou empêcher la circulation de fluide dans ledit conduit. Selon un mode de réalisation, le conduit 10 est pourvu d'une pompe 11 destinée à mettre le fluide sous pression. Le conduit 10 est également connecté à un réservoir 12 de fluide. Divers actionneurs et/ou dispositifs 13a, 13b, 13c (vérin, pompe, moteur, frein, ...) peuvent être connectés aux différentes portions du conduit : entre la pompe 11 et la valve V et/ou entre la valve V et le réservoir 12 et/ou entre le réservoir 12 et la pompe 11. La valve V peut également être utilisée dans un système de génération d'électricité comme expliqué plus avant dans la description.

L'invention est illustrée principalement en lien avec un liquide hydraulique, mais bien entendu l'invention n'est pas limitée à cette application et peut être utilisée avec d'autres fluides, notamment un fluide gazeux. Le liquide hydraulique peut être utilisé comme moyen de transmission de puissance dans un système hydraulique. Il s'agit par exemple d'une huile minérale incompressible capable de transmettre rapidement l'énergie d'une pompe aux actionneurs et/ou dispositifs 13a, 13b, 13c.

La valve V est du type valve Bath, c'est-à-dire une valve type à plaque de Hörbiger mue par un actionneur piézoélectrique. Elle comprend une entrée E de fluide sous pression et une sortie S de fluide. Selon un mode de réalisation, la sortie S est une sortie basse pression, par exemple connectée au réservoir 12 mis à pression atmosphérique (1 bar). Selon un autre mode de réalisation, la sortie S est une sortie où le fluide est toujours sous pression. La valve V comporte une plaque fixe P et un clapet mobile C opposé à ladite plaque.

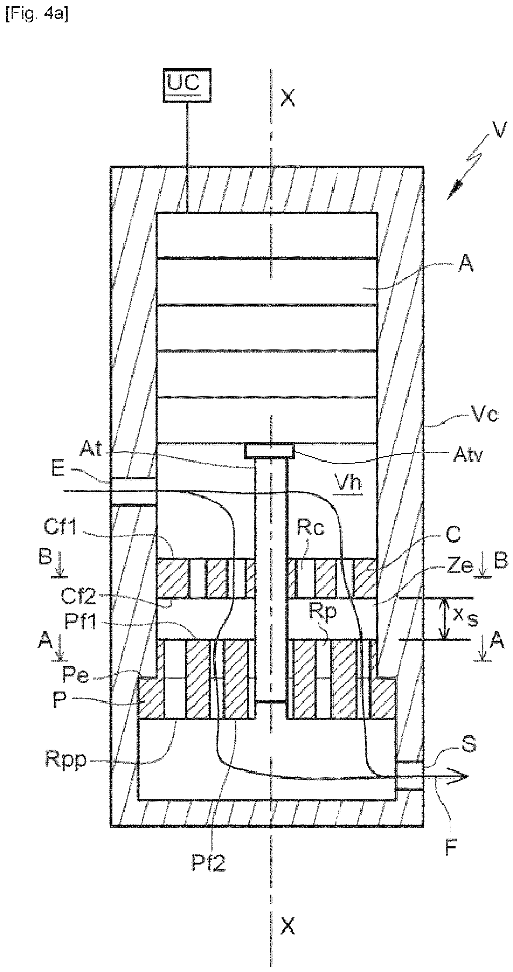

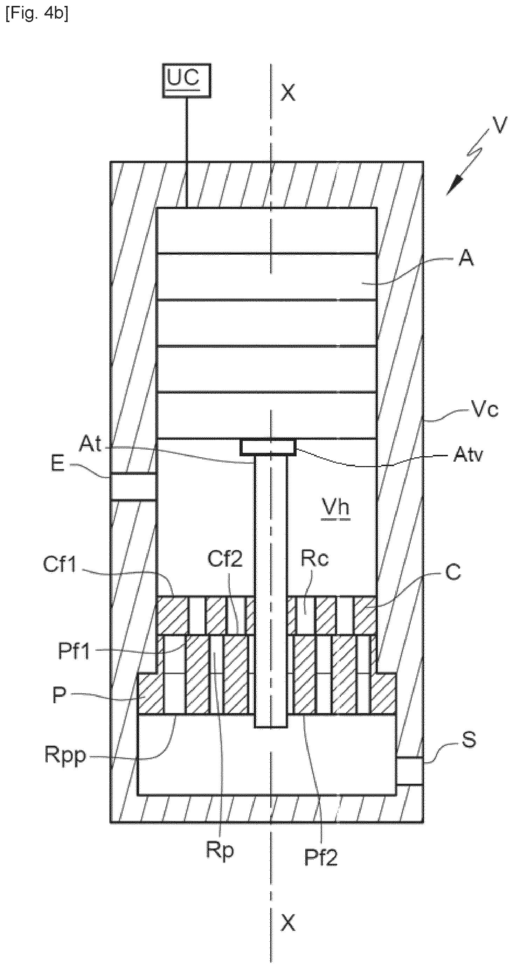

Pour des facilités de montage et de conception, la plaque P a une forme générale cylindrique de section circulaire. Sur les figures 4a et 4b, elle présente un épaulement Pe assurant son positionnement dans le corps de valve Vc. Le corps de valve Vc est rigide, par exemple réalisé en acier, préférentiellement obtenu par moulage et usinage.

La plaque P présente une première face Pf1 et une seconde face Pf2 opposées. La première face Pf1 est en vis-à-vis du clapet C. La plaque P est rigide. Selon un mode préféré de réalisation, elle est réalisée en acier, préférentiellement obtenue par usinage. Son diamètre est par exemple compris entre 10 mm et 50 mm, et sa hauteur (ou épaisseur) comprise entre 2 mm et 10 mm. La plaque P est maintenue en position dans le corps de valve Vc, par exemple par un emmanchement serré ou par soudage.

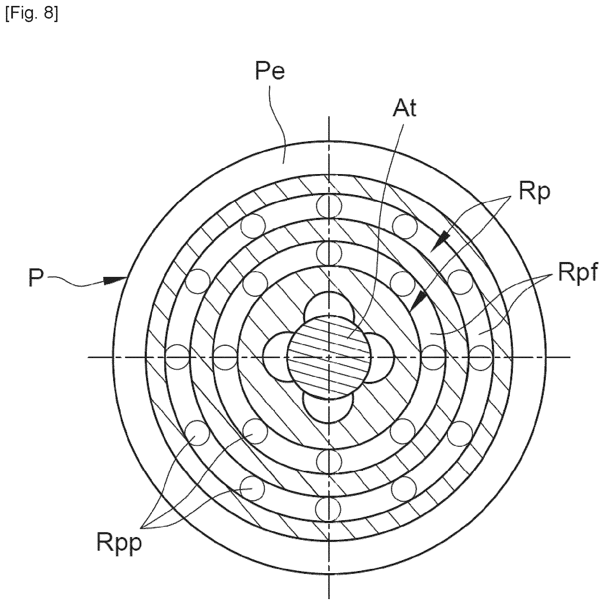

Des premiers canaux de passage de fluide Rp sont aménagés dans la plaque P. Selon le mode de réalisation de la figure 8, ces canaux Rp se présentent sous la forme de rainures annulaires concentriques, dont le nombre peut varier de 1 à 10 selon le diamètre de la plaque P. À titre d'exemple, les rainures Rp ont une largeur comprise entre 0,5 mm et 10 mm et une profondeur comprise entre 0,5 mm et 10 mm. Selon le mode de réalisation des figures 4a, 4b et 8, les rainures Rp débouchent au niveau de la première face Pf1, mais ne sont pas traversantes, c'est-à-dire qu'elles ne sont pas réalisées dans toute l'épaisseur de la plaque P. En d'autres termes, elles présentent une paroi de fond Rpf. Des perçages Rpp sont réalisés au niveau de la paroi de fond Rpf et débouchent au niveau de la seconde face Pf2. Les canaux Rp sont donc formés des rainures annulaires et des perçages Rpp. Le diamètre des perçages Rpp correspond à la largeur des rainures Rp. Leur nombre peut varier de 4 à 20 par rainure. Cette conception présente plusieurs avantages : elle permet d'obtenir une plaque P particulièrement rigide qui empêche ou limite les déformations et donc les risques de fuite. Elle permet en outre de générer des pertes de charge négligeables lors du passage du fluide.

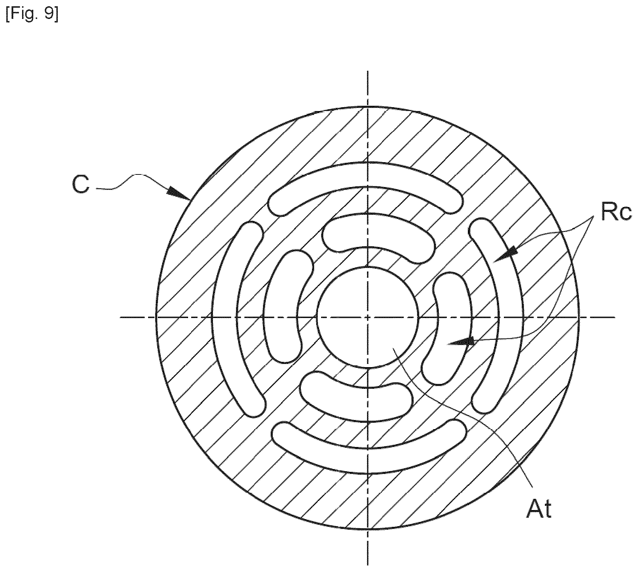

Selon une autre mode de réalisation, les canaux Rp se présentent sous la forme de segments de rainures annulaires concentriques, dont le nombre peut varier de 1 à 10 selon le diamètre de la plaque P. À titre d'exemple, les segments de rainures Rp ont une largeur comprise entre 0,5 mm et 10 mm et une profondeur correspondantes à l'épaisseur de la plaque P. Selon un mode de réalisation, les segments de rainures Rp sont traversants, c'est-à-dire qu'ils sont réalisés dans toute l'épaisseur de la plaque P et débouchent au niveau de la première face Pf1 et de la seconde face Pf2. Cette conception permet d'obtenir une plaque P rigide qui empêche ou limite les déformations. On constate en outre des pertes de charge négligeables lors du passage du fluide. Cette conception est similaire à celle des premiers canaux Rp décrits plus avant dans la description, notamment en référence à la figure 9.

Pour des facilités de montage et de conception, le clapet C a également une forme générale cylindrique de section circulaire, et de manière plus générale à la même forme, ou sensiblement la même forme, que la plaque P. Le clapet C est rigide, par exemple réalisé en acier, préférentiellement obtenu par moulage et usinage. Il est monté mobile entre une position d'ouverture (figures 4a, 5a, 6a, 7a) et une position de fermeture (figures 4b, 5b, 6b, 7b).

En se rapportant aux figures 4a et 4b, le clapet C présente une première face Cf1 et une seconde face Cf2 opposées. La deuxième face Cf2 du clapet C est en vis-à-vis de la première face Pf1 de la plaque P. Selon un mode préféré de réalisation, le clapet C est réalisé en acier, préférentiellement obtenu par usinage. Son diamètre correspond à celui de la plaque P et est par exemple compris entre 10 mm et 50 mm, sa hauteur (ou épaisseur) étant comprise entre 2 mm et 10 mm.

Des seconds canaux de passage de fluide Rc sont aménagés dans la plaque P. Selon le mode de réalisation de la figure 9, ces canaux Rc se présentent sous la forme de segments de rainures annulaires concentriques, dont le nombre peut varier de 1 à 10 selon le diamètre du clapet C. À titre d'exemple, les segments de rainures Rc ont une largeur comprise entre 0,5 mm et 10 mm et une profondeur comprise entre 0,5 mm et 10 mm. Selon le mode de réalisation des figures 4a, 4b, 5a, 5b, 6a, 6b, 7a, 7b et 9, les segments de rainures Rc sont traversants, c'est-à-dire qu'ils sont réalisés dans toute l'épaisseur du clapet C et qu'ils débouchent au niveau de la première face Cf1 et de la seconde face Cf2. Cette conception permet non seulement d'obtenir un clapet C particulièrement rigide qui empêche ou limite les déformations, mais également de générer des pertes de charge négligeables lors du passage du fluide.

Les premiers canaux Rp et les seconds canaux Rc sont dans une configuration de coopération. En se rapportant aux figures 4a, 4b, 8 et 9, la plaque P et le clapet C présentent, respectivement au niveau de la première Pf1 et de la seconde face Cf2, des parties creuses (correspondantes aux canaux Rp, Rc) et des parties pleines bordant lesdites parties creuses (correspondant aux zones hachurées).

Lorsque le clapet C et la plaque P sont en vis-à-vis, les premiers canaux Rp de ladite plaque sont disposés en face des parties pleines dudit clapet. Et les seconds canaux Rc du clapet C sont disposés en face des parties pleines de la plaque P. En position de fermeture (figures 4b, 5b, 6b, 7b), lorsque le clapet C est en contact avec la plaque P, les premiers canaux Rp sont obturées par les parties pleines dudit clapet et les seconds canaux Rc sont obturées par les parties pleines de ladite plaque. Ainsi, en position de fermeture, les premiers canaux Rp et les seconds canaux Rc ne sont pas en communication fluidique. Pour obturer efficacement les canaux Rp, Rc, les parties pleines complémentaires sont plus larges que lesdits canaux, par exemple plus large de 0,2 mm à 2 mm.

À l'inverse, dans la position d'ouverture (figures 4a, 5a, 6a, 7a), le clapet C est espacé de la plaque P, les premiers canaux Rp ne sont plus obturées par les parties pleines dudit clapet et les seconds canaux Rc ne sont plus obturées par les parties pleines de ladite plaque. Les premiers canaux Rp et les seconds canaux Rc sont alors en communication fluidique.

Le clapet C est déplacé entre la position de fermeture et la position d'ouverture, par un actionneur piézoélectrique A adapté pour produire une énergie mécanique lorsqu'il est polarisé électriquement. L'actionneur A consiste en une structure d'empilement d'éléments piézoélectriques (également désigné dans la suite par l'expression « pilier piézoélectrique ») ou en une membrane piézoélectrique. Les éléments piézoélectriques se présentent avantageusement sous la forme de rondelles ou disques pièzocéramiques ou piezocomposites dont le diamètre est par exemple compris entre 5 mm et 50 mm. Le nombre de rondelles ou disques peut varier de 3 à 400 selon la longueur du pilier (qui peut être comprise entre 5 mm et 200 mm) et/ou selon la force mécanique à générer. À titre d'exemple, on utilise des rondelles céramiques dures PZT (Titano-Zirconate de Plomb). Dans le cas d'une membrane piézoélectrique, il s'agit avantageusement d'un composant de la famille du polyvinylidine difluoride (PVDF), plus particulièrement un dérivé PVDF tel qu'un PVDF/PDMS (PDMS : polydiméthylsiloxane).

Lorsque l'actionneur A est mis sous tension, ses éléments piézoélectriques se polarisent et se déforment élastiquement pour générer une contrainte mécanique. Selon un mode de réalisation, la déformation élastique consiste en un allongement du pilier piézoélectrique selon l'axe longitudinal X-X de l'actionneur A, qui est également l'axe de translation du clapet C. En d'autres termes, l'actionneur A s'allonge lorsqu'il est mis sous tension. Et lorsqu'il n'est pas mis sous tension, l'actionneur A se rétracte et revient à sa position d'origine.

La mise sous tension de l'actionneur A est gérée par une unité de commande UC qui peut par exemple se présenter sous la forme d'un processeur, microprocesseurs, CPU (pour Central Processing Unit), intégré dans un terminal électronique (ordinateur, automate, ...). À titre d'exemple, le signal de commande généré par l'unité de commande UC et appliqué à l'actionneur A peut avoir une tension comprise entre 0 V et 1000 V, sous une intensité de 2 A à 10 A. La fréquence d'activation de l'actionneur A (fréquence d'ouverture/fermeture de la valve V) peut atteindre 2000 Hz. L'unité de commande UC peut adapter le signal de commande, en tension et/ou en intensité pour optimiser les performances en termes de rapidité (temps d'ouverture/fermeture) et/ou de précision de déplacement du clapet C, et/ou de bruit émis, etc. Par exemple, un signal de commande sinusoïdale réduit le bruit généré par le déplacement du clapet C comparé à un signal de commande carré.

L'actionneur A est dimensionné pour déplacer le clapet C d'une distance xₛ. En d'autres termes, en position d'ouverture, la distance séparant la première face Pf1 de la plaque P de la seconde face Cf2 du clapet est xₛ. Cette distance est avantageusement comprise entre 20 µm et 150 µm. Le débit de fluide susceptible de traverser la valve V peut être facilement contrôlé en réglant la tension appliquée à l'actionneur A, lequel réglage permet d'ajuster la déformation dudit actionneur et de fait cette distance xₛ. Par exemple, pour une distance de déplacement xₛ d'environ 80 µm, on obtient un débit de 10 L/min pour un fluide à 5 bars, un débit de 15 L/min pour un fluide à 10 bars et un débit de 80 L/min pour un fluide à 300 bars.

### Premier mode de réalisation : figures 4a et 4b.

Sur les figures 4a et 4b, le clapet C est disposé au niveau de la première chambre Vh. En d'autres termes, la première chambre Vh est disposée de part et d'autre de l'actionneur A et du clapet C. Encore en d'autres termes, le clapet C est disposé entre l'actionneur A et la plaque P.

Les éléments piézoélectriques sont montés sur une tige At installée selon l'axe X-X. Les éléments piézoélectriques peuvent notamment être percés selon l'axe X-X ce qui permet d'y insérer la tige At. L'allongement ou la rétractation de l'actionneur A induit une translation de la tige At selon l'axe X-X.

Selon un mode de réalisation, lorsque l'actionneur A est mis sous tension, il s'allonge de sorte que le clapet C est déplacé vers la position de fermeture. Et lorsqu'il n'est pas mis sous tension, l'actionneur A se rétracte et revient à sa position d'origine, le clapet C se déplaçant alors vers la position d'ouverture. Dans ce montage, la valve V est donc naturellement ouverte : le clapet C est en position d'ouverture lorsque l'actionneur A n'est pas sous tension. Un montage inverse peut toutefois être envisagé, dans lequel la valve V est naturellement fermée, le clapet C étant en position de fermeture lorsque l'actionneur A n'est pas sous tension (et qu'il s'allonge et revient à sa position d'origine).

Selon un mode préféré de réalisation, l'actionneur A est dimensionné pour délivrer une force mécanique comprise entre 1000 N (Newtons) et 10000 N.

Selon un mode de réalisation, la tige At est en prise avec le clapet C de sorte que la translation de ladite tige entraîne la translation dudit clapet entre les positions d'ouverture et de fermeture. Le clapet C peut être solidarisé à la tige At par emmanchement serré, par soudage, par vissage ou toute autre solution convenant à l'homme du métier.

La tige At se prolonge vers la plaque P. Cette dernière présente un orifice central faisant office de guidage de la tige At. Cette conception permet de guider avec précision la translation du clapet C entre les positions d'ouverture et fermeture et d'assurer une coopération optimale dudit clapet et de la plaque en position de fermeture.

Les seconds canaux Rc sont aménagés dans le clapet C de sorte qu'ils débouchent dans la première chambre Vh au niveau de la première face Cf1 et/ou soient en communication fluidique avec ladite chambre. La première face Cf1 est par la suite dénommée « face active » du clapet C. Cette face active Cf1 présente également des parties creuses (correspondantes aux canaux Rc) et des parties pleines bordant lesdites parties creuses, dans un agencement qui peut être similaire à celui de la figure 9. L'entrée E de la valve V est disposée en amont du clapet C, au niveau de la première chambre Vh, et la sortie S est disposée en aval de la plaque P, au niveau d'une deuxième chambre d'écoulement Ve, en communication fluidique avec les premiers canaux Rp. Dans cette configuration, en position d'ouverture, la circulation du fluide au travers de la valve V est la suivante : i) le fluide pénètre dans la première chambre Vh par l'entrée E, ii) le fluide s'écoule au travers du clapet C en passant par les seconds canaux Rc, depuis la première face Cf1 vers la seconde face Cf2, iii) le fluide s'écoule dans la zone d'espacement Ze séparant le clapet C de la plaque P, iv) le fluide s'écoule au travers de la plaque P en passant par les premiers canaux Rp, depuis la première face Pf1 vers la seconde face Pf2, v) le fluide ressort de la valve V par la deuxième chambre Ve et la sortie S.

Lorsque le fluide sous pression pénètre dans la première chambre Vh, il exerce une force sur la face active Cf1 du clapet C, et plus particulièrement sur ses parties pleines. Cette force est orientée vers la plaque P de sorte que le clapet C est contraint vers la position de fermeture. En position de fermeture, cette force de pression se combine à celle exercée par l'actionneur A pour plaquer avec une contrainte maximale ledit clapet contre la plaque P. Cela contribue à fortement améliorer l'étanchéité de la valve V en position de fermeture.

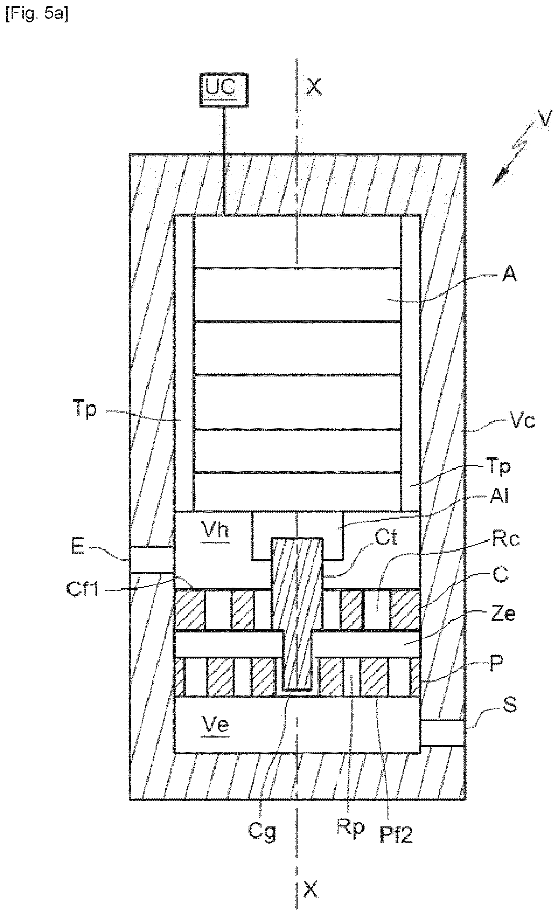

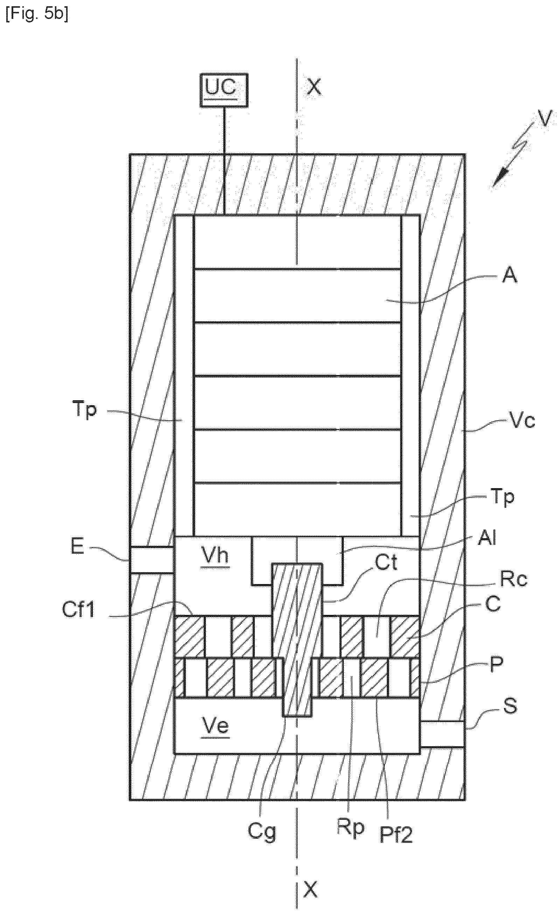

### Deuxième mode de réalisation : figures 5a et 5b.

Le positionnement de la plaque P et du clapet C correspond à celui du premier mode de réalisation : la plaque P est disposée au niveau de la deuxième chambre Ve et le clapet C au niveau de la première chambre Vh (le clapet C est disposé de part et d'autre de l'actionneur A et de la plaque P). Et le fonctionnement de la valve V est similaire à celui décrit en référence au premier mode.

Ce deuxième mode de réalisation se distingue du premier mode par la coopération du clapet C avec l'actionneur A. Ce dernier n'est plus pourvu d'une tige centrale. Il présente, au niveau de l'une de ses extrémités, une pièce de liaison Al sur laquelle vient se fixer le clapet C. Selon un mode de réalisation, le clapet C comporte, au niveau de sa face active Cf1, un élément en saillie Ct se présentant par exemple sous la forme d'une tige ou tenon, adapté pour se fixer sur la pièce de liaison Al, par exemple par vissage.

Le clapet C comporte, au niveau de son autre face Cf2, un autre élément en saillie Cg se présentant par exemple sous la forme d'une tige ou tenon, qui se prolonge vers la plaque P. Cette dernière présente un orifice central faisant office de guidage et dans lequel se loge l'élément en saillie Cg. C'est donc maintenant la coopération de cet autre élément en saillie Cg avec l'orifice de guidage de la plaque P qui permet de guider avec précision la translation du clapet C entre les positions d'ouverture et fermeture et d'assurer une coopération optimale dudit clapet et de ladite plaque en position de fermeture.

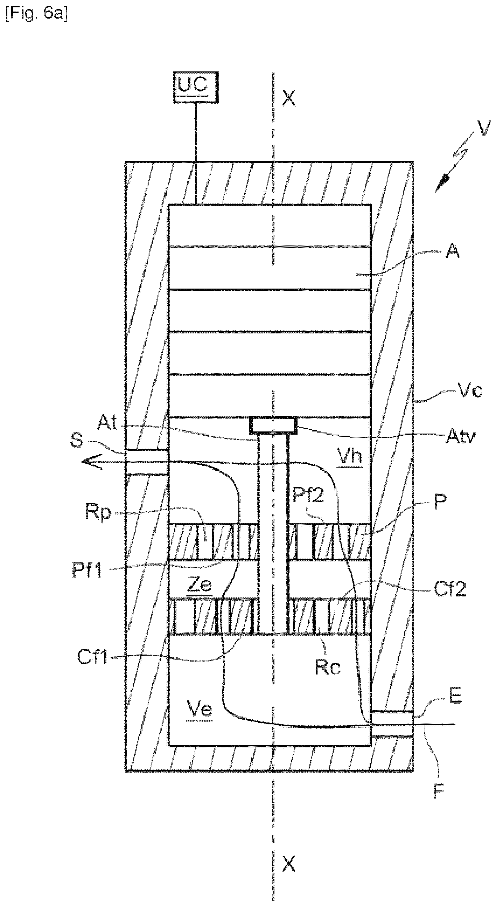

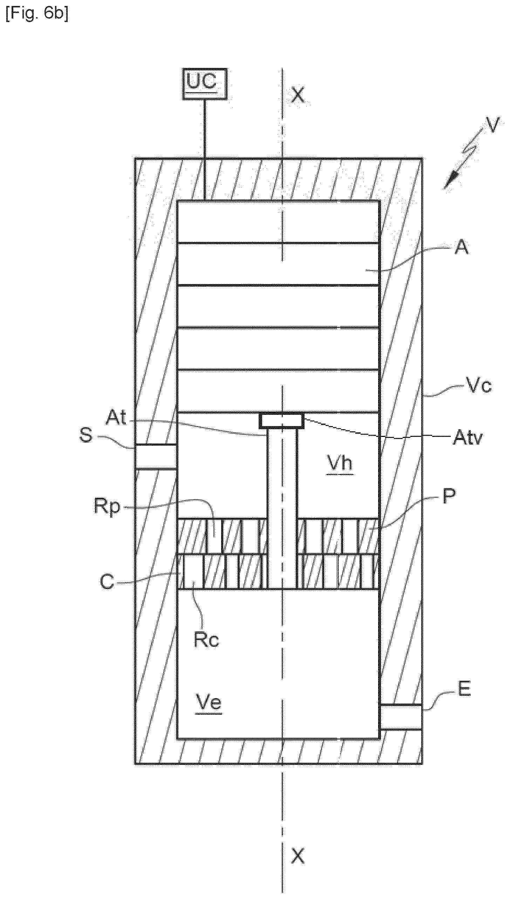

### Troisième mode de réalisation : figures 6a et 6b.

Comme dans le premier mode de réalisation, la tige At est en prise avec le clapet C de sorte que la translation de ladite tige entraîne la translation dudit clapet.

Toutefois, le positionnement de la plaque P et de clapet C est inversé par rapport à celui des deux premiers modes de réalisation : le clapet C est disposé au niveau de la deuxième chambre Ve et la plaque P au niveau de la première chambre Vh. La première chambre Vh est donc maintenant disposée de part et d'autre de l'actionneur A et de la plaque fixe P. En d'autres termes, c'est maintenant la plaque P qui est disposée entre l'actionneur A et le clapet C.

Selon un mode de réalisation, lorsque l'actionneur A est mis sous tension, il s'allonge de sorte que le clapet C est déplacé vers la position d'ouverture. Et lorsqu'il n'est pas mis sous tension, l'actionneur A se rétracte et revient à sa position d'origine, le clapet C se déplaçant alors vers la position de fermeture. Dans ce montage, la valve V est donc naturellement fermée : le clapet C est en position de fermeture lorsque l'actionneur A n'est pas sous tension. Un montage inverse peut toutefois être envisagé, dans lequel la valve V est naturellement ouverte, le clapet C étant en position d'ouverture lorsque l'actionneur A n'est pas sous tension (et qu'il se rétracte et revient à sa position d'origine).

Les seconds canaux Rc du clapet C débouchent dans la deuxième chambre Ve au niveau de la face active Cf1 et/ou sont en communication fluidique avec ladite chambre. L'entrée E est disposée au niveau de la deuxième chambre Ve et la sortie S est disposée au niveau de la première chambre Vh, en communication fluidique avec les premiers canaux Rp. Dans cette configuration, en position d'ouverture, la circulation du fluide au travers de la valve V est la suivante : i) le fluide pénètre dans la deuxième chambre Ve par l'entrée E, ii) le fluide s'écoule au travers du clapet C en passant par les seconds canaux Rc, depuis la première face Cf1 vers la seconde face Cf2, iii) le fluide s'écoule dans la zone d'espacement Ze séparant le clapet C de la plaque P, iv) le fluide s'écoule au travers de la plaque P en passant par les premiers canaux Rp, depuis la première face Pf1 vers la seconde face Pf2, v) le fluide ressort de la valve V par la première chambre Vh et la sortie S.

Lorsque le fluide sous pression pénètre dans la deuxième chambre Ve, il exerce une force sur la face active Cf1 du clapet C. Cette force est orientée vers la plaque P de sorte que le clapet C est contraint vers la position de fermeture. En position de fermeture, cette force de pression contribue à plaquer le clapet contre la plaque P avec une contrainte maximale. Cela contribue à fortement améliorer l'étanchéité de la valve V en position de fermeture.

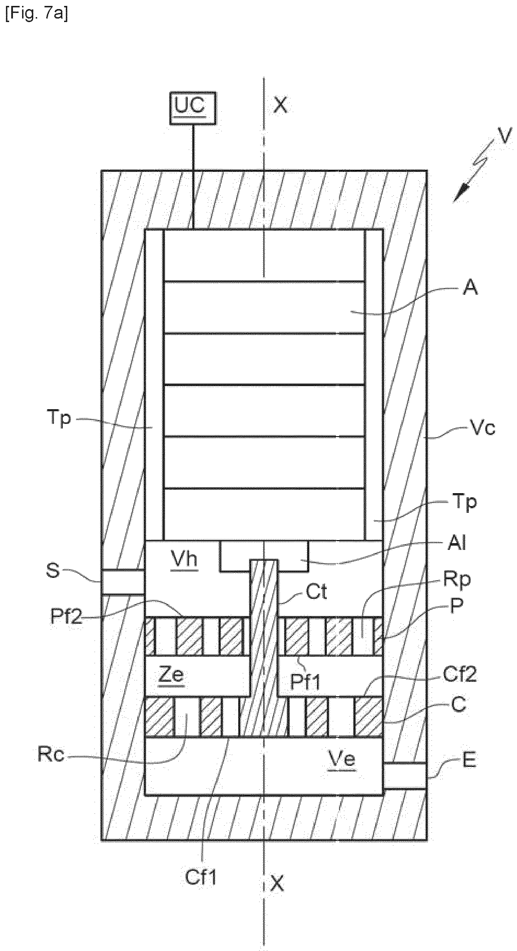

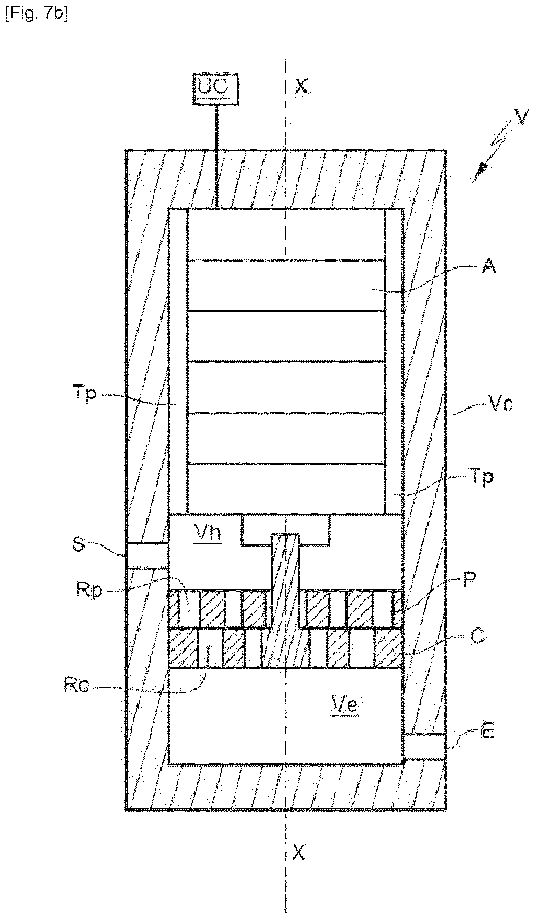

### Quatrième mode de réalisation : figures 7a et 7b.

Le fonctionnement de la valve V et le positionnement de la plaque P et du clapet C correspondent à ceux du troisième mode de réalisation : la plaque P est disposée au niveau de la première chambre Vh et le clapet C au niveau de la deuxième chambre Ve (la plaque P est disposée de part et d'autre de l'actionneur A et du clapet C).

Et la coopération du clapet C avec l'actionneur A et la plaque C correspond sensiblement à celui décrit en référence au deuxième mode de réalisation. L'actionneur A présente, à l'une de ses extrémités, une pièce de liaison Al sur laquelle vient se fixer le clapet C. Selon un mode de réalisation, le clapet C comporte, au niveau de sa face Cf2, un élément en saillie Ct se présentant par exemple sous la forme d'une tige ou tenon, adapté pour se fixer sur la pièce de liaison Al, par exemple par vissage. Cet élément en saillie Ct passe au travers d'un orifice central de la plaque P faisant office de guidage.

Ce quatrième mode de réalisation combine donc les avantages des deuxième et troisième modes de réalisation.

Quel que soit le mode de réalisation, on constate que plus la pression du fluide est importante, plus la contrainte de pression exercée sur le clapet C en position de fermeture est élevée, contribuant de fait à améliorer l'étanchéité de la valve V. Comparée à la valve Bath précitée, la valve V objet de l'invention n'est donc pas limitée en pression.

En outre, dans valve Bath, les temps d'ouverture/fermeture sont limités par la pression maximale d'utilisation. La valve V objet de l'invention n'étant pas soumise à cette limite, les temps d'ouverture/fermeture peuvent être davantage réduits et être de l'ordre de 0,5 ms, voire inférieure. Notamment, lorsque le clapet C se déplace de la position d'ouverture vers la position de fermeture, la force de pression exercée par le fluide sur ledit clapet tend à accélérer son mouvement. Aussi, plus la pression est importante, plus les temps de fermeture de la valve V sont réduits. La demanderesse a pu constater de manière expérimentale que pour une distance de déplacement xₛ d'environ 80 µm et pour un fluide à 5 bars les temps d'ouverture/fermeture étaient inférieurs à 0,5 ms (de l'ordre de 0,3 ms). On observe une réduction de ce temps d'ouverture/fermeture de 10% à 100 bars et de 20% à 300 bars.

### Tige(s) de précontrainte

Quel que soit le mode de réalisation, l'actionneur A est avantageusement précontraint pour améliorer la tenue mécanique du pilier piézoélectrique. Une précontrainte axiale est appliquée sur le pilier piézoélectrique, par compression dudit pilier.

Dans le premier mode de réalisation (figure 4a, 4b) et le troisième mode de réalisation (figures 6a, 6b), un ou des éléments de visserie Atv sont en prise avec la tige At de manière à appliquer cette précontrainte sur le pilier piézoélectrique.

Dans le deuxième mode de réalisation (figures 5a, 5b) et le quatrième mode de réalisation (figures 7a, 7b), la précontrainte est générée par des tiges Tp placées en périphérie du pilier, par exemple trois tiges Tp placées à 120°, en prises avec des éléments de visserie et assurant la liaison entre la pièce AI et l'extrémité dudit pilier. On comprendra que la ou les tiges Tp peuvent être employées dans les premier et troisième modes de réalisation (en complément ou en substitution des éléments de visserie Atv) et que le ou les éléments de visserie Atv peuvent être employés dans les deuxième et quatrième modes de réalisation (en complément ou en substitution des tiges Tp).

À titre d'exemple, les tiges At, Tp sont réalisées en acier STUBS^{®}, leur diamètre étant compris entre 1 mm et 5 mm et leur longueur comprise entre 80 mm et 200 mm.

Le ou ces tiges de précontrainte At, Tp ont une double fonction. D'une part elles permettent de soumettre le pilier piézoélectrique à des contraintes permanentes de compression axiale permettant notamment d'assurer un contact permanent entre les différents éléments piézoélectriques empilés. D'autre part, les tiges de précontrainte At, Tp forment des éléments ressort dont la force de rappel agit dans le sens de la rétractation du pilier piézoélectrique et de fait décuple la vitesse de rétractation dudit pilier.

Dans les premier et deuxième modes de réalisation, lorsque l'actionneur A est mis sous tension, il s'allonge de sorte que le clapet C est déplacé vers la position de fermeture. L'allongement de l'actionneur A entraîne également celui des tiges de précontrainte At, Tp de sorte que lesdites tiges sont contraintes en traction et mises en tension. Lorsque l'actionneur A n'est plus alimenté, il se rétracte et revient à sa position d'origine. Les tiges de précontrainte At, Tp reviennent également à leur position d'origine et agissent comme un ressort de rappel sur le pilier piézoélectrique de sorte que le déplacement du clapet C vers la position d'ouverture est accéléré. De par la configuration des tiges de précontrainte At, Tp, la force de rappel qu'elles exercent (correspondant à la contrainte en traction à laquelle elles sont soumises) permet d'ouvrir plus rapidement le clapet C, cette force participant à lutter contre la pression qui s'exerce sur la face active Cf1 dudit clapet lorsqu'il passe de la position de fermeture à la position d'ouverture.

Dans les troisième et quatrième modes de réalisation, la force de rappel exercée par les tiges de précontrainte At, Tp agit dans le sens du déplacement du clapet C vers la position de fermeture, lequel déplacement étant ainsi accéléré. La force de rappel exercée par les tiges de précontrainte At, Tp permet donc de fermer plus rapidement le clapet C, cette force se combinant à l'effort de pression qui s'exerce sur la face active Cf1 dudit clapet lors de la phase de fermeture.

Les tiges de précontrainte At, Tp permettent ainsi de réduire encore davantage les temps d'ouverture/fermeture de la valve, notamment lorsque la pression du fluide est importante. La demanderesse a pu constater de manière expérimentale qu'en comparaison d'un pilier piézoélectrique non précontraint (par exemple avec le même pilier, mais où les éléments piézoélectriques sont collés entre eux), les tiges de précontrainte At, Tp permettaient une réduction du temps d'ouverture (pour les premier et deuxième modes de réalisation) et de fermeture (pour les troisième et quatrième modes de réalisation) de 20% à 100 bars et de 30% à 300 bars.

Les meilleurs résultats en termes de rapidité d'ouverture/fermeture sont obtenus lorsque la raideur totale des tiges de précontrainte At, Tp est comprise entre 10% et 20% de la raideur du pilier piézoélectrique seul. En d'autres termes, le pilier piézoélectrique d'origine (non précontraint) est 5 à 10 fois plus raide que les tiges de précontrainte At, Tp. À titre d'exemple, le pilier piézoélectrique seul présente une raideur de 96 MN/m (méga Newton par mètre) et l'ensemble des tiges At, Tp, une raideur de 16,5 MN/m (soit 5,5 MN/m par tige, si trois tiges de précontraintes sont utilisées).

Les meilleurs résultats en termes de rapidité d'ouverture/fermeture sont en outre obtenus lorsque la force de précontrainte appliquée sur le pilier piézoélectrique est comprise entre 5% et 20% de la force mécanique délivrée par le pilier piézoélectrique seul. En d'autres termes, la force délivrée par le pilier piézoélectrique d'origine (non précontraint) est 5 à 20 fois plus importante que la force de précontrainte appliquée par les tiges de précontrainte At, Tp. À titre d'exemple, si le pilier piézoélectrique délivre une force mécanique de 10 kN (Kilo Newton), la force de précontrainte appliquée par l'ensemble des tiges At, Tp, est comprise entre 0,5 kN et 2 kN (soit entre 0,15 et 0,7 kN par tige, si trois tiges de précontraintes sont utilisées).

### Utilisation de la valve objet de l'invention

La valve V peut être utilisée comme une valve simple, dans des applications classiques, notamment pour bloquer ou laisser passer du fluide dans le but d'alimenter ou non un ou plusieurs actionneurs ou composants hydrauliques.

Un autre aspect de l'invention concerne l'utilisation de la valve V dans un procédé et un système de génération d'électricité utilisant un générateur piézoélectrique pour produire une énergie électrique. On entend par l'expression « générateur piézoélectrique » tous matériaux piézoélectriques ou éléments piézoélectriques ou encore association desdits matériaux/éléments capables de se polariser électriquement sous l'action d'une contrainte mécanique et réciproquement de se déformer lorsqu'on leur applique un champ électrique. En l'espèce, le matériau piézoélectrique est en premier lieu utilisé pour produire une énergie électrique lorsqu'il est soumis à une contrainte mécanique.

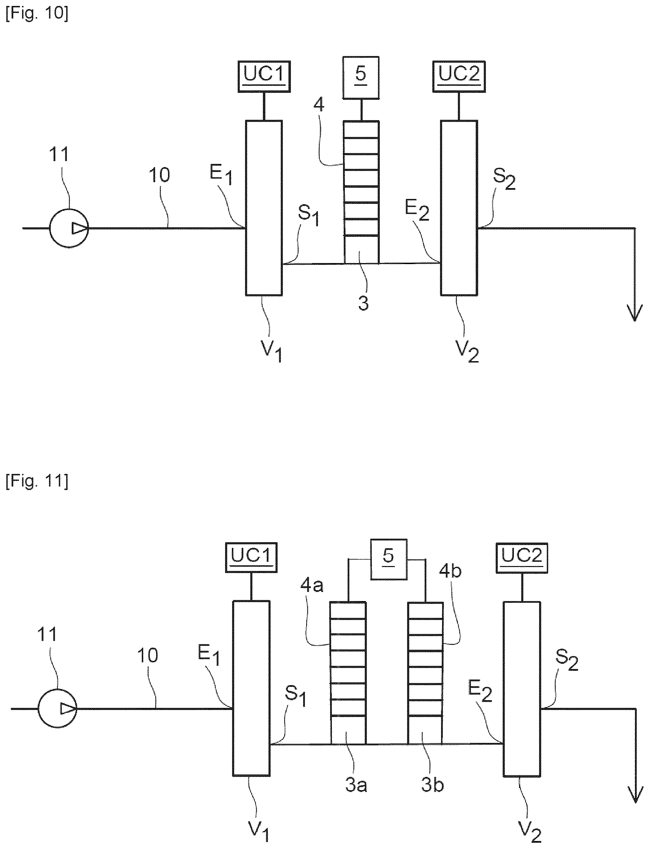

La figure 10 illustre un mode d'exécution reprenant les éléments d'un système de génération d'électricité selon l'invention, à savoir un circuit 10, plus précisément une portion du circuit, dans laquelle circule un fluide sous pression (par exemple entre 5 bars et 300 bars) et sur laquelle ou au niveau de laquelle est aménagé une cavité fluidique 3 logeant un empilement ou pilier piézoélectrique 4 formant le générateur piézoélectrique. Ce pilier 4 est connecté à un circuit électronique d'extraction de charges 5. La cavité 3 est installée entre deux valves conformes à l'invention, respectivement une valve d'admission V1 et une valve d'échappement V2, lesquelles valves sont montées en série.

Le conduit 10 peut par exemple consister en une dérivation réalisée sur une canalisation de fluide sous pression d'une installation type éolienne, hydrolienne, houlomotrice, etc.

Dans une première séquence, la valve d'admission V1 est pilotée pour que son clapet soit en position d'ouverture et la valve d'échappement V2 est pilotée pour que son clapet soit en position de fermeture. Le fluide sous pression circulant dans le circuit 10, pénètre et remplis au moins partiellement la cavité fluidique 3 de manière à engendrer une pression mécanique sur le pilier piézoélectrique 4. Cette pression entraîne une déformation du pilier 4 de sorte qu'il génère des charges électriques, également désignées en tant qu'énergie électrique, qui sont récupérées par le circuit électronique d'extraction de charges 5.

Suite à cette première séquence de fonctionnement, une deuxième séquence de fonctionnement comprend la fermeture de la valve d'admission V1 et l'ouverture de la valve d'échappement V2. Le fluide s'échappe de la cavité fluidique 3 de sorte que le pilier 4 n'est plus contraint et retrouve son état initial au repos (sans pression exercée par le fluide). La déformation inverse conduisant le générateur piézoélectrique 4 à retrouver son état initial permet à nouveau la génération de charges électriques, pouvant encore être récupérées par le circuit électronique de récupération de charges 5. Ainsi, le système permet de récupérer de l'énergie électrique d'une part lors de la pénétration du fluide sous pression dans la cavité fluidique 3 et d'autre part lors de l'évacuation dudit fluide de ladite cavité.

Ainsi, si l'on compare la première séquence et la deuxième séquence, les valves d'admission V1 et d'échappement V2 présentent respectivement des positions d'ouverture/fermeture inverses ou opposées. Autrement, lorsqu'une - par exemple la valve d'admission V1 - est ouverte, l'autre valve V2 est fermée et les deux séquences sont avantageusement intimement liées l'une à l'autre dans le cadre de la présente invention. L'invention est caractérisée, dans un tel système spécifique, par l'alternance de la première séquence et de la deuxième séquence susmentionnées. Par ailleurs, la fréquence de survenue de la première séquence et/ou de la deuxième séquence, est modifiable ou adaptable en fonction de différents paramètres, dont en particulier la fréquence de résonance du générateur piézoélectrique 4, laquelle fréquence de résonance est elle-même modifiable en modifiant la raideur dudit générateur piézoélectrique.

Selon un mode de réalisation permettant de simplifier la conception, les valves V1 et V2 sont identiques. Elles sont par exemple conçues selon le premier mode (figures 4a et 4b) ou selon le deuxième mode (figures 5a, 5b) ou selon le troisième mode (figures 6a, 6b) ou selon le quatrième mode (figures 7a, 7b).

Dans une variante, les valves V1 et V2 sont distinctes. Elles sont notamment conçues selon deux modes de réalisation distincts. De manière avantageuse, la valve d'admission V1 est conçue selon le premier mode (figures 4a et 4b) ou selon le deuxième mode (figures 5a, 5b), et la valve de d'échappement V2 selon le troisième mode (figures 6a, 6b) ou selon le quatrième mode (figures 7a, 7b). Le fluide traversant les valves V1 et V2 présente une certaine compressibilité, même légère dans le cas d'un liquide. On peut donc observer une variation relative de son volume lorsqu'il circule sous pression entre les deux valves V1 et V2 et qu'il pénètre dans la cavité fluidique 3. Cette variation de volume induit une perte de puissance. Il est donc préférable que cette variation de volume soit la plus faible possible pour réduire au maximum la perte de puissance. Or, le volume de la première chambre Vh peut être différent de celui de la deuxième chambre Ve. Et en pratique, le volume de la première chambre Vh est supérieur à celui de la deuxième chambre Ve. Lors de la première séquence de fonctionnement précitée (valve d'admission V1 ouverte et valve d'échappement V2 fermée), il est avantageux que le fluide pénètre dans la chambre de la valve d'échappement V2 qui présente le volume le plus faible, c'est-à-dire dans la deuxième chambre Ve. C'est la raison pour laquelle la valve de d'échappement V2 est avantageusement selon le troisième mode (figures 6a, 6b) ou selon le quatrième mode (figures 7a, 7b).

Il est à noter que la cavité fluidique 3 présente un volume variable dû à la contraction du générateur piézoélectrique 4 lorsque le fluide pénètre dans ladite cavité et à la détente dudit générateur lorsque ledit fluide s'échappe de ladite cavité. La variation du volume de la cavité fluidique 3 peut être réglable, notamment en réglant la raideur du générateur piézoélectrique 4. Cette variation du volume de la cavité fluidique 3 a un effet direct sur le débit du liquide circulant dans le conduit 10 et de ce fait sur le couple de la pompe 11.

Selon un mode de réalisation, le pilier piézoélectrique 4 se compose d'un empilement de céramiques piézoélectriques alternées avec des électrodes fabriquées dans un matériau conducteur, comme par exemple le cuivre ou le bronze. À titre d'exemple, on utilise des rondelles céramiques dures PZT. Les électrodes sont câblées en parallèle ou en série. Le nombre de céramiques et d'électrodes varie de 2 à 50, voire 150. Ces céramiques et électrodes ont la même forme et ont préférentiellement une section circulaire. Elles sont percées axialement. À titre d'exemple, leur diamètre externe est compris entre 0,5 cm et 20 cm, et leur épaisseur comprise entre 1 mm et 100 mm. Le diamètre du perçage axial est par exemple compris entre 0,5 cm et 10 cm. Les perçages axiaux assurent un alignement axial des céramiques et des électrodes. Lorsque les céramiques et les électrodes sont empilées, les perçages axiaux délimitent un alésage central coaxial à l'axe du pilier 4. Cet alésage central permet le passage d'une tige qui assure le centrage, l'alignement et participe au maintien des céramiques et des électrodes. Des moyens de fixation sont disposés aux extrémités de la tige. Ces moyens de fixation se présentent par exemple sous la forme de pièces rigides fixées aux extrémités de la tige de manière à venir enserrer l'empilement des céramiques et des électrodes. La pièce se présente par exemple sous la forme d'un écrou vissé à l'extrémité filetée de la tige. La pièce peut également être un écrou, ou une pièce taraudée, fixée à un châssis, et dans laquelle se visse l'autre extrémité filetée de la tige. Pour des raisons de sécurité, l'empilement des céramiques et des électrodes est avantageusement isolé électriquement. Pour ce faire, la tige peut être placée dans un fourreau ou gaine fabriquée dans un matériau isolant électrique tel qu'un plastique. On peut également prévoir de loger l'empilement dans un fourreau ou dans une gaine extérieure également fabriquée dans un matériau isolant électrique.

Le circuit électronique d'extraction de charges 5 récupère l'énergie électrique - les électrons libérés - provenant du générateur piézoélectrique 4. Selon un mode de réalisation, il comprend : un interrupteur haute tension à commande, avantageusement un thyristor ; un pont redresseur de tension ; une inductance dont le raccordement avec le générateur piézoélectrique 4 constitue un circuit résonnant du type LC, l'élément capacitif étant constitué par le pilier lui-même, une capacité ou un condensateur de filtrage mis en parallèle ; un système de stockage permettant de stoker cette énergie électrique avant son conditionnement pour une utilisation sur un réseau. Ce système de stockage consiste par exemple en une batterie ou un banc de super-capacités.

Lorsque le générateur piézoélectrique 4 est soumis à une excitation alternative (selon les séquences décrites précédemment), et durant la phase croissante de la contrainte, l'interrupteur est maintenu ouvert. Le générateur piézoélectrique 4 est en circuit ouvert et les charges électriques s'accumulent aux bornes dudit pilier, ce dernier fonctionnant comme une capacité. Lorsque la contrainte mécanique appliquée au générateur piézoélectrique 4 est maximale, l'interrupteur est brièvement fermé pendant une durée correspondant à une demi-période de la résonance du circuit LC. Ainsi, l'ensemble des charges électriques accumulées aux bornes du générateur piézoélectrique 4 sont extraites dudit pilier par le circuit 5. Durant la phase décroissante de la contrainte, le générateur piézoélectrique 4se recharge. Lorsque la contrainte est minimale, l'interrupteur est de nouveau brièvement fermé pendant une durée correspondant à une demi-période de la résonance du circuit LC, de manière à extraire les charges électriques. Puis le cycle reprend avec l'alternance des premières et deuxièmes séquences.

La configuration du circuit électronique d'extraction de charges 5 est adaptée pour maximiser l'énergie électrique produite par le générateur piézoélectrique 4. Cette configuration permet en effet de doubler l'énergie électrique générée par le générateur piézoélectrique 4 en la récupérant une première fois lors de la mise sous contrainte dudit générateur par le fluide sous pression (première séquence décrite ci-dessus), et une seconde fois lors de son relâchement (deuxième séquence décrite ci-dessus).

Selon un mode de réalisation, la fréquence d'ouverture/fermeture des valves V1 et V2, c'est-à-dire la fréquence de la première ou de la deuxième séquence, est commandée grâce à leur unité de commande respective UC1, UC2, pour que cette fréquence d'ouverture/fermeture, ou de la première ou deuxième séquence, corresponde à la fréquence de résonnance du générateur piézoélectrique 4 de manière à récupérer un maximum d'énergie électrique. Un tel fonctionnement optimum dans lequel la récupération de charges ou d'énergie électrique est maximum est évidemment possible avec tous les modes d'exécution. Selon une variante de réalisation, une seule unité de commande UC1 ou UC2 est utilisée pour commander la fréquence d'ouverture/fermeture des valves V1 et V2.

La fréquence de résonnance du générateur piézoélectrique 4 s'établit entre 10 Hz et 1000 Hz. L'utilisation des valves ultra-rapides V1, V2 conforme à l'invention permettent d'assurer aisément des fréquences d'excitation supérieures à 100 Hz et pouvant atteindre 1000 Hz.

La figure 11 illustre une variante de réalisation où plusieurs cavités fluidiques 3a, 3b sont installées dans le conduit 10, entre les valves V1 et V2. Ce mode de réalisation permet de récupérer davantage d'énergie électrique. Chaque cavité fluidique 3 loge un générateur piézoélectrique 4a, 4b. Ces générateurs 4a, 4b sont ici connectés à circuit électronique d'extraction de charges 5 commun, mais on peut prévoir de connecter chaque générateur à son propre circuit électronique d'extraction de charges.

Le système de génération d'électricité qui vient d'être décrit est particulièrement simple, fiable et robuste dans sa conception et peut être facilement intégré dans tout type d'installation comprenant un circuit de fluide sous pression étant donné sa simplicité de mise en œuvre. Ce système est en outre relativement peu onéreux, tant au niveau du montage/installation et/ou de la fabrication qu'au niveau des différents éléments composant un tel système.

L'agencement des différents éléments et/ou moyens et/ou étapes de l'invention, dans les modes de réalisation décrits ci-dessus, ne doit pas être compris comme exigeant un tel agencement dans toutes les implémentations. En tout état de cause, on comprendra que diverses modifications peuvent être apportées à ces éléments et/ou moyens et/ou étapes, sans s'écarter de l'esprit et de la portée de l'invention. En particulier :
- La plaque P et/ou le clapet C peuvent avoir une section autre que circulaire, par exemple une section carrée, rectangulaire, polygonale, ovale, etc.
- Les premiers canaux Rp peuvent se présenter sous la forme de segments de rainures annulaires, ou uniquement sous la forme de perçages débouchant, ou sous d'autres formes telles que des rainures ou segments de rainures non annulaires et/ou non concentriques.
- Les rainures annulaires Rp peuvent être traversantes, c'est-à-dire réalisées dans toute l'épaisseur de la plaque P et débouchées au niveau de chacune des faces Pf1 et Pf2.
- Les seconds canaux Rc peuvent se présenter sous la même forme que les premiers canaux Rp (rainures + perçages), ou uniquement sous la forme de perçages débouchant, ou sous d'autres formes telles que des rainures ou segments de rainures non annulaires et/ou non concentriques.
- Le générateur piézoélectrique 4 peut se présenter sous la forme d'une membrane piézoélectrique, par exemple constituée d'un matériau de la famille du PVDF, plus particulièrement un dérivé PVDF tel qu'un PVDF/PDMS.

En outre, une ou plusieurs caractéristiques exposées seulement dans un mode de réalisation peuvent être combinées avec une ou plusieurs autres caractéristiques exposées seulement dans un autre mode de réalisation. De même, une ou plusieurs caractéristiques exposées seulement dans un mode de réalisation peuvent être généralisées aux autres modes de réalisation, même si ce ou ces caractéristiques sont décrites seulement en combinaison avec d'autres caractéristiques.

L'usage du verbe « comporter », « comprendre » ou « inclure » et de ses formes conjuguées n'exclut pas la présence d'autres éléments ou d'autres étapes que ceux énoncés dans une revendication.

## Revendications

1. Valve comprenant une entrée (E) de fluide sous pression et une sortie (S) de fluide, laquelle valve (V) comporte :
- une plaque fixe (P) dans laquelle sont aménagés des premiers canaux de passage de fluide (Rp),
- un clapet (C) dans lequel sont aménagés des seconds canaux de passage de fluide (Rc), ledit clapet étant monté mobile entre :
∘ une position d'ouverture dans laquelle les premiers canaux (Rp) et les seconds canaux (Rc) sont dans une configuration autorisant le passage du fluide entre l'entrée (E) et la sortie (S),
∘ une position de fermeture dans laquelle les premiers canaux (Rp) et les seconds canaux (Rc) sont dans une configuration bloquant le passage du fluide entre l'entrée (E) et la sortie (S),
- un actionneur piézoélectrique (A) agissant sur le clapet (C) pour le déplacer entre la position de fermeture et la position d'ouverture, lequel actionneur consiste en un pilier piézoélectrique formé par une structure d'empilement d'éléments piézoélectriques, lequel pilier s'allonge lorsque l'actionneur est mis sous tension et se rétracte lorsque ledit actionneur n'est pas sous tension, l'entrée (E) étant est aménagée de sorte qu'en usage, le fluide sous pression exerce une force de pression sur une face active (Cf1) dudit clapet contraignant ledit clapet vers la position de fermeture,
**caractérisé en ce que** l'actionneur (A) est précontraint axialement au moyen d'une ou plusieurs tiges de précontrainte (At, Tp) formant des éléments ressort dont la force de rappel agit dans le sens de la rétractation du pilier piézoélectrique.

2. Valve selon la revendication 1, dans laquelle la force de précontrainte appliquée par la ou les tiges de précontrainte (At, Tp) sur le pilier piézoélectrique est comprise entre 5% et 20% de la force mécanique délivrée par ledit pilier piézoélectrique seul.

3. Valve selon l'une des revendications 1 ou 2, dans laquelle la ou les tiges de précontrainte (At, Tp) présentent une raideur comprise entre 10% et 20% de la raideur du pilier piézoélectrique seul.

4. Valve selon l'une des revendications précédentes, dans laquelle :
- en position d'ouverture, le clapet (C) est espacé de la plaque (P) de sorte que les premiers canaux (Rp) et les seconds canaux (Rc) sont en communication fluidique,
- en position de fermeture, le clapet (C) est en contact avec la plaque (P) de sorte que les premiers canaux (Rp) et les seconds canaux (Rc) ne sont pas en communication fluidique.

5. Valve selon l'une des revendications précédentes, dans laquelle :
- le clapet (C) est monté mobile dans une chambre (Vh, Ve) entre la position d'ouverture et la position de fermeture,
- les seconds canaux (Rc) sont en communication fluidique avec la chambre (Vh, ve),
- l'entrée (E) est disposée en amont du clapet (C), au niveau de la chambre (Vh, Ve),
- la sortie (S) est disposée en aval de la plaque (P), en communication fluidique avec les premiers canaux (Rp) de sorte qu'en usage et en position d'ouverture, le fluide circule des seconds canaux (Rc) vers lesdits premiers canaux.

6. Valve selon l'une des revendications 1 à 5, dans laquelle l'actionneur piézoélectrique (A) est configuré de sorte que le clapet (C) soit naturellement en position d'ouverture lorsque ledit actionneur n'est pas sous tension, la ou les tiges de précontrainte (At, Tp) étant configurées de sorte que la force de rappel exercée par ladite ou lesdites tiges agisse contre la force de pression qui s'exerce, en usage, sur la face active (Cf1) dudit clapet lorsque ledit clapet passe de la position de fermeture à la position d'ouverture.

7. Valve selon la revendication 6, dans laquelle le clapet (C) est disposé entre l'actionneur (A) et la plaque (P).

8. Valve selon l'une des revendications 1 à 5, dans laquelle l'actionneur piézoélectrique (A) est configuré de sorte que le clapet (C) soit naturellement en position de fermeture lorsque ledit actionneur n'est pas sous tension, la ou les tiges de précontrainte (At, Tp) étant configurées de sorte que la force de rappel exercée par ladite ou lesdites tiges se combine à la force de pression qui s'exerce, en usage, sur la face active (Cf1) dudit clapet lorsque ledit clapet passe de la position d'ouverture à la position de fermeture.

9. Valve selon la revendication 8, dans laquelle la plaque (P) est disposée entre l'actionneur (A) et le clapet (C).

10. Valve selon l'une des revendications 1 à 9, dans laquelle :
- les éléments piézoélectriques sont montés sur une tige (At) précontrainte installée selon un axe de translation (X-X),
- la tige (At) est en prise avec le clapet (C) de sorte qu'une translation de ladite tige induite par l'actionneur piézoélectrique (A) entraîne la translation dudit clapet entre les positions d'ouverture et de fermeture.

11. Valve selon la revendication 10, dans laquelle la plaque (P) présente un orifice central dans lequel se loge la tige (At), ledit orifice faisant office de guidage de ladite tige.

12. Valve selon l'une des revendications 1 à 9, dans laquelle :
- l'actionneur piézoélectrique (A) présente, au niveau de l'une de ses extrémités, une pièce de liaison (Al) sur laquelle vient se fixer le clapet (C),
- le clapet (C) comporte, au niveau d'une face, un élément en saillie (Ct) adapté pour se fixer sur la pièce de liaison (AI).

13. Valve selon la revendication 12 prise en combinaison avec la revendication 9, dans laquelle
- le clapet (C) comporte, au niveau d'une autre face, un autre élément en saillie (Cg) se prolongeant vers la plaque (P),
- la plaque (P) présente un orifice central dans lequel se loge ledit autre élément en saillie (Cg), ledit orifice faisant office de guidage dudit autre élément en saillie (Cg).

14. Système de génération d'électricité comportant :
- un circuit (10) dans lequel circule un fluide sous pression,
- au moins une cavité fluidique (3) aménagée sur au moins une portion du circuit (10), laquelle cavité loge un générateur piézoélectrique (4) relié à un circuit électronique d'extraction de charges (5) apte à récupérer l'énergie électrique provenant dudit générateur piézoélectrique (4),
et dans lequel :
- la cavité fluidique (3) est installée entre deux valves conformes à l'une des revendications 1 à 13, respectivement une valve d'admission (V1) et une valve d'échappement (V2),
- dans une première séquence de fonctionnement, la valve d'admission (V1) est pilotée pour que son clapet soit en position d'ouverture et la valve d'échappement (V2) est pilotée pour que son clapet soit en position de fermeture, de sorte que le fluide sous pression pénètre et rempli au moins partiellement la cavité fluidique (3) de manière à engendrer une pression mécanique sur le générateur piézoélectrique (4), laquelle pression entraîne une déformation dudit générateur générant une énergie électrique récupérée par le circuit électronique d'extraction de charges (5),
- dans une deuxième séquence de fonctionnement, la valve d'admission (V1) est pilotée pour que son clapet soit en position de fermeture et la valve d'échappement (V2) est pilotée pour que son clapet soit en position d'ouverture, de sorte que le fluide sous pression s'échappe de la cavité fluidique (3) et que le générateur piézoélectrique (4) ne soit plus contraint.

15. Système selon la revendication 14, dans lequel la fréquence d'ouverture/fermeture des valves d'admission (V1) et d'échappement (V2), est commandée de sorte qu'elle corresponde à la fréquence de résonnance du générateur piézoélectrique (4).

16. Système selon l'une des revendications 14 ou 15, dans lequel la valve d'admission (V1) est conforme à la revendication 7 et la valve d'échappement (V2) est conforme à la revendication 9.

17. Procédé pour accélérer l'ouverture/fermeture d'une valve, laquelle valve comprend une entrée (E) de fluide sous pression et une sortie (S) de fluide, et comporte :
- une plaque fixe (P) dans laquelle sont aménagés des premiers canaux de passage de fluide (Rp),
- un clapet (C) dans lequel sont aménagés des seconds canaux de passage de fluide (Rc), ledit clapet étant monté mobile entre :
∘ une position d'ouverture dans laquelle les premiers canaux (Rp) et les seconds canaux (Rc) sont dans une configuration autorisant le passage du fluide entre l'entrée (E) et la sortie (S),
∘ une position de fermeture dans laquelle les premiers canaux (Rp) et les seconds canaux (Rc) sont dans une configuration bloquant le passage du fluide entre l'entrée (E) et la sortie (S),
- un actionneur piézoélectrique (A) agissant sur le clapet (C) pour le déplacer entre la position de fermeture et la position d'ouverture, lequel actionneur consiste en un pilier piézoélectrique formé par une structure d'empilement d'éléments piézoélectriques, lequel pilier s'allonge lorsque l'actionneur est mis sous tension et se rétracte lorsque ledit actionneur n'est pas sous tension,
ledit procédé comprenant les étapes consistant à :
- aménager l'entrée (E) de sorte qu'en usage, le fluide sous pression exerce une force de pression sur une face active (Cf1) du clapet (C) contraignant ledit clapet vers la position de fermeture,
- précontraindre axialement l'actionneur (A) au moyen d'une ou plusieurs tiges de précontrainte (At, Tp) formant des éléments ressort dont la force de rappel agit dans le sens de la rétractation du pilier piézoélectrique.

## Patentansprüche

1. Ventil, das einen Druckfluideingang (E) und einen Fluidausgang (S) umfasst, wobei das Ventil (V) beinhaltet:
- eine feste Platte (P), in der erste Fluiddurchgangskanäle (Rp) vorgesehen sind,
- eine Klappe (C), in der zweite Fluiddurchgangskanäle (Rc) vorgesehen sind, wobei die Klappe beweglich montiert ist zwischen:
∘ einer Öffnungsposition, in der die ersten Kanäle (Rp) und die zweiten Kanäle (Rc) in einer Konfiguration sind, die den Durchgang des Fluids zwischen dem Eingang (E) und dem Ausgang (S) zulässt,
∘ einer Schließposition, in der die ersten Kanäle (Rp) und die zweiten Kanäle (Rc) in einer Konfiguration sind, die den Durchgang des Fluids zwischen dem Eingang (E) und dem Ausgang (S) blockiert,
- ein piezoelektrisches Stellglied (A), das auf die Klappe (C) einwirkt, um sie zwischen der Schließposition und der Öffnungsposition zu verschieben, wobei das Stellglied aus einer piezoelektrischen Säule besteht, die aus einer Stapelstruktur von piezoelektrischen Elementen gebildet ist, wobei sich die Säule verlängert, wenn das Stellglied unter Spannung gesetzt wird, und sich zurückzieht, wenn das Stellglied nicht unter Spannung steht, wobei der Eingang (E) vorgesehen ist, sodass im Gebrauch das Druckfluid eine Druckkraft auf eine aktive Seite (Cf1) der Klappe ausübt, wodurch die Klappe in die Schließposition gezwungen wird,
**dadurch gekennzeichnet, dass** das Stellglied (A) axial mittels einer oder mehrerer Vorspannstangen (At, Tp) vorgespannt ist, wordurch Federelemente gebildet werden, deren Rückstellkraft in Richtung des Zurückziehens der piezoelektrischen Säule einwirkt.

2. Ventil nach Anspruch 1, wobei die von der oder den Vorspannstangen (At, Tp) auf die piezoelektrische Säule ausgeübte Vorspannkraft zwischen 5 % und 20 % der von der piezoelektrischen Säule allein abgegebenen mechanischen Kraft beträgt.

3. Ventil nach einem der Ansprüche 1 oder 2, wobei die Vorspannstange(n) (At, Tp) eine Steifigkeit aufweist bzw. aufweisen, die zwischen 10 % und 20 % der Steifigkeit der piezoelektrischen Säule allein liegt.

4. Ventil nach einem der vorstehenden Ansprüche, wobei:
- das Rückschlagventil (C) in Öffnungsposition von der Platte (P) beabstandet ist, sodass die ersten Kanäle (Rp) und die zweiten Kanäle (Rc) in fluidischer Verbindung stehen,
- die Klappe (C) in Schließposition in Kontakt mit der Platte (P) steht, sodass die ersten Kanäle (Rp) und die zweiten Kanäle (Rc) nicht in fluidischer Verbindung stehen.

5. Ventil nach einem der vorstehenden Ansprüche, wobei:
- die Klappe (C) beweglich in einer Kammer (Vh, Ve) zwischen der Öffnungsposition und der Schließposition montiert ist,
- die zweiten Kanäle (Rc) in fluidischer Verbindung mit der Kammer (Vh, ve) stehen,
- der Eingang (E) stromaufwärts der Klappe (C) auf Höhe der Kammer (Vh, Ve) angeordnet ist,
- der Ausgang (S) stromabwärts der Platte (P) in fluidischer Verbindung mit den ersten Kanälen (Rp) angeordnet ist, sodass das Fluid im Gebrauch und in Öffnungsposition von den zweiten Kanälen (Rc) zu den ersten Kanälen zirkuliert.

6. Ventil nach einem der Ansprüche 1 bis 5, wobei das piezoelektrische Stellglied (A) konfiguriert ist, sodass sich die Klappe (C) natürlich in Öffnungsposition befindet, wenn das Stellglied nicht unter Spannung steht, wobei die Vorspannstange(n) (At, Tp) konfiguriert ist bzw. sind, sodass die von der oder den Stangen ausgeübte Rückstellkraft gegen die Druckkraft wirkt, die im Gebrauch auf die aktive Seite (Cf1) der Klappe ausgeübt wird, wenn die Klappe von der Schließposition in die Öffnungsposition übergeht.

7. Ventil nach Anspruch 6, wobei die Klappe (C) zwischen dem Stellglied (A) und der Platte (P) angeordnet ist.

8. Ventil nach einem der Ansprüche 1 bis 5, wobei das piezoelektrische Stellglied (A) konfiguriert ist, sodass sich die Klappe (C) natürlich in Schließposition befindet, wenn das Stellglied nicht unter Spannung steht, wobei die Vorspannstange(n) (At, Tp) konfiguriert ist bzw. sind, sodass die von der oder den Stangen ausgeübte Rückstellkraft mit der Druckkraft kombiniert wird, die im Gebrauch auf die aktive Seite (Cf1) der Klappe ausgeübt wird, wenn die Klappe von der Öffnungsposition in die Schließposition übergeht.

9. Ventil nach Anspruch 8, wobei die Platte (P) zwischen dem Stellglied (A) und der Klappe (C) angeordnet ist.

10. Ventil nach einem der Ansprüche 1 bis 9, wobei:
- die piezoelektrischen Elemente auf einer vorgespannten Stange (At) montiert sind, die entlang einer Vorschubsachse (X-X) installiert ist,
- die Stange (At) mit der Klappe (C) in Eingriff steht, sodass ein vom piezoelektrischen Stellglied (A) induzierter Vorschub der Stange den Vorschub der Klappe zwischen der Öffnungs- und der Schließposition antreibt.

11. Ventil nach Anspruch 10, wobei die Platte (P) eine zentrale Öffnung aufweist, in der sich die Stange (At) befindet, wobei die Öffnung als Führungsöffnung der Stange dient.

12. Ventil nach einem der Ansprüche 1 bis 9, wobei:
- das piezoelektrische Stellglied (A) an einem seiner Enden ein Verbindungsstück (Al) aufweist, an dem die Klappe (C) befestigt wird,
- die Klappe (C) auf einer Seite ein vorstehendes Element (Ct) beinhaltet, das angepasst ist, um am Verbindungsstück (Al) befestigt zu werden.

13. Ventil nach Anspruch 12 in Kombination mit Anspruch 9, wobei:
- die Klappe (C) an einer anderen Seite ein anderes vorstehendes Element (Cg) beinhaltet, das sich zur Platte (P) hin ausdehnt,
- die Platte (P) eine zentrale Öffnung aufweist, in der das andere vorstehende Element (Cg) aufgenommen ist, wobei die Öffnung als Führungsöffnung des anderen vorstehenden Elements (Cg) dient.

14. Stromerzeugungssystem, das beinhaltet:
- einen Kreislauf (10), in dem ein Druckfluid zirkuliert,
- mindestens einen Fluidhohlraum (3), der an mindestens einem Abschnitt des Kreislaufs (10) vorgesehen ist, wobei im Hohlraum ein piezoelektrischer Generator (4) aufgenommen ist, der mit einem elektronischen Ladungsextraktionskreislauf (5) verbunden ist, der imstande ist, die elektrische Energie aus dem piezoelektrischen Generator (4) zurückzugewinnen, und wobei:
- der Fluidhohlraum (3) zwischen zwei Ventilen nach einem der Ansprüche 1 bis 13, jeweils einem Einlassventil (V1) und einem Auslassventil (V2) installiert ist,
- das Einlassventil (V1) in einer ersten Betriebssequenz angesteuert wird, damit seine Klappe in Öffnungsposition ist, und das Auslassventil (V2) angesteuert wird, damit seine Klappe in Schließposition ist, sodass das Druckfluid in den Fluidhohlraum (3) eindringt und diesen zumindest teilweise füllt, um einen mechanischen Druck auf den piezoelektrischen Generator (4) hervorzurufen, wobei der Druck zu einer Verformung des Generators führt, wodurch elektrische Energie erzeugt wird, die vom elektronischen Ladungsextraktionskreislauf (5) zurückgewonnen wird,
- das Einlassventil (V1) in einer zweiten Betriebssequenz angesteuert wird, damit seine Klappe in Schließposition ist, und das Auslassventil (V2) angesteuert wird, damit seine Klappe in Öffnungsposition ist, sodass das Druckfluid aus dem Fluidhohlraum (3) entweicht und der piezoelektrische Generator (4) nicht mehr belastet wird.

15. System nach Anspruch 14, wobei die Öffnungs- /Schließfrequenz des Einlassventils (V1) und des Auslassventils (V2) gesteuert wird, um der Resonanzfrequenz des piezoelektrischen Generators (4) zu entsprechen.

16. System nach einem der Ansprüche 14 oder 15, wobei das Einlassventil (V1) Anspruch 7 entspricht und das Auslassventil (V2) Anspruch 9 entspricht.

17. Verfahren zum Beschleunigen des Öffnens/Schließens eines Ventils, wobei das Ventil einen Druckfluideingang (E) und einen Fluidausgang (S) umfasst und beinhaltet:
- eine feste Platte (P), in der erste Fluiddurchgangskanäle (Rp) vorgesehen sind,
- eine Klappe (C), in der zweite Fluiddurchgangskanäle (Rc) vorgesehen sind, wobei die Klappe beweglich montiert ist zwischen:
∘ einer Öffnungsposition, in der die ersten Kanäle (Rp) und die zweiten Kanäle (Rc) in einer Konfiguration sind, die den Durchgang des Fluids zwischen dem Eingang (E) und dem Ausgang (S) zulässt,
∘ einer Schließposition, in der die ersten Kanäle (Rp) und die zweiten Kanäle (Rc) in einer Konfiguration sind, die den Durchgang des Fluids zwischen dem Eingang (E) und dem Ausgang (S) blockiert,
- ein piezoelektrisches Stellglied (A), das auf die Klappe (C) einwirkt, um sie zwischen der Schließposition und der Öffnungsposition zu verschieben, wobei das Stellglied aus einer piezoelektrischen Säule besteht, die aus einer Stapelstruktur von piezoelektrischen Elementen gebildet ist, wobei sich die Säule verlängert, wenn das Stellglied unter Spannung gesetzt wird, und sich zurückzieht, wenn das Stellglied nicht unter Spannung steht, wobei das Verfahren die Schritte umfasst, bestehend aus:
- Einrichten des Eingangs (E), sodass das Druckfluid im Gebrauch eine Druckkraft auf eine aktive Seite (Cf1) der Klappe (C) ausübt, wodurch die Klappe in die Schließposition gezwungen wird,
- axial Vorspannen des Stellglieds (A) mittels einer oder mehrerer Vorspannstangen (At, Tp), die Federelemente bilden, deren Rückstellkraft in Richtung des Zurückziehens der piezoelektrischen Säule wirkt.

## Claims

1. Valve comprising a pressurised fluid inlet (E) and a fluid outlet (S), said valve (V) comprising:
- a fixed plate (P) wherein first fluid flow channels (Rp) are formed,
- a shutter (C) wherein second fluid flow channels (Rc) are formed, said shutter being movably mounted between:
∘ an open position wherein the first channels (Rp) and the second channels (Rc) are in a configuration allowing the flow of the fluid between the inlet (E) and the outlet (S),
∘ a closed position wherein the first channels (Rp) and the second channels (Rc) are in a configuration blocking the flow of the fluid between the inlet (E) and the outlet (S),
- a piezoelectric actuator (A) acting on the shutter (C) to move it between the closed position and the open position, which actuator consists of a piezoelectric pillar formed by a stacking structure of piezoelectric elements, which pillar extends when the actuator is powered and retracts when said actuator is not powered, the inlet (E) being arranged such that, in use, the pressurised fluid exerts a pressure force on an active face (Cf1) of said shutter forcing said shutter towards the closed position,
**characterised in that** the actuator (A) is axially prestressed by means of one or more prestressing rods (At, Tp) forming spring elements in which the restoring force acts in the direction of retraction of the piezoelectric pillar.

2. Valve according to claim 1, wherein the prestress force applied by the prestressing rod(s) (At, Tp) on the piezoelectric pillar is between 5% and 20% of the mechanical force delivered by said piezoelectric pillar alone.

3. Valve according to any one of claims 1 or 2, wherein the prestressing rod(s) (At, Tp) have a rigidity between 10% and 20% of the rigidity of the piezoelectric pillar alone.

4. Valve according to any one of the preceding claims, wherein:
- in the open position, the shutter (C) is spaced apart from the plate (P) in such a way that the first channels (Rp) and the second channels (Rc) are in fluidic communication,
- in the closed position, the shutter (C) is in contact with the plate (P) in such a way that the first channels (Rp) and the second channels (Rc) are not in fluid communication.

5. Valve according to any one of the preceding claims, wherein:
- the shutter (C) is movably mounted in a chamber (Vh, Ve) between the open position and the closed position,
- the second channels (Rc) are in fluidic communication with the chamber (Vh, ve),
- the inlet (E) is disposed upstream of the shutter (C), in the vicinity of the chamber (Vh, Ve),
- the outlet (S) is disposed downstream of the plate (P), in fluidic communication with the first channels (Rp), in such a way that, in use and in the open position, the fluid flows from the second channels (Rc) to said first channels.

6. Valve according to any one of claims 1 to 5, wherein the piezoelectric actuator (A) is configured in such a way that the shutter (C) is naturally in the open position when said actuator is not powered, the prestressing rod(s) (At, Tp) being configured in such a way that the restoring force exerted by said rod(s) acts against the pressure force exerted, in use, on the active face (Cf1) of said shutter when said shutter switches from the closed position to the open position.

7. Valve according to claim 6, wherein the shutter (C) is disposed between the actuator (A) and the plate (P).

8. Valve according to any one of claims 1 to 5, wherein the piezoelectric actuator (A) is configured in such a way that the shutter (C) is naturally in the closed position when said actuator is not powered, the prestressing rod(s) (At, Tp) being configured in such a way that the restoring force exerted by said rod(s) is combined with the pressure force exerted, in use, on the active face (Cf1) of said shutter when said shutter switches from the open position to the closed position.

9. Valve according to claim 8, wherein the plate (P) is disposed between the actuator (A) and the shutter (C).

10. Valve according to any one of claims 1 to 9, wherein:
- the piezoelectric elements are mounted on a prestressing rod (At) installed along a translational axis (X-X),
- the rod (At) is engaged with the shutter (C) in such a way that the translation of said rod induced by the piezoelectric actuator (A) entails the translation of said shutter between the open and closed positions.

11. Valve according to claim 10, wherein the plate (P) has a central orifice wherein the rod (At) is housed, said orifice acting as a guide for said rod.

12. Valve according to any one of claims 1 to 9, wherein:
- the piezoelectric actuator (A) has, in the vicinity of one of its ends, a connecting part (Al) to which the shutter (C) is attached,
- the shutter (C) comprises, in the vicinity of one face, a projecting element (Ct) adapted to be attached to the connecting part (Al).

13. Valve according to claim 12 taken in conjunction with claim 9, wherein:
- the shutter (C) comprises, in the vicinity of another face, another projecting element (Cg) extending towards the plate (P),
- the plate (P) has a central orifice wherein said other projecting element (Cg) is housed, said orifice acting as a guide for said other projecting element (Cg).

14. Electricity-generating system comprising:
- a circuit (10) wherein a pressurised fluid circulates,
- at least one fluidic cavity (3) formed on at least one portion of the circuit (10), said cavity housing a piezoelectric generator (4) connected to an electronic load extraction circuit (5) capable of recovering the electrical energy from said piezoelectric generator (4), and wherein:
- the fluidic cavity (3) is installed between two valves according to any one of claims 1 to 13, respectively an inflow valve (V1) and a relief valve (V2),
- in a first operating sequence, the inflow valve (V1) is controlled so that its shutter is in the open position, and the relief valve (V2) is controlled so that its shutter is in the closed position, in such a way that the pressurised fluid enters and fills at least partially the fluidic cavity (3) so as to induce a mechanical pressure on the piezoelectric generator (4), said pressure producing a deformation of said generator generating an electrical energy recovered by the electronic load extraction circuit (5),
- in a second operating sequence, the inflow valve (V1) is controlled so that its shutter is in the closed position, and the relief valve (V2) is controlled so that its shutter is in the open position, in such a way that the pressurised fluid is discharged from the fluidic cavity (3) and the piezoelectric generator (4) is no longer stressed.

15. System according to claim 14, wherein the open/closed frequency of the inflow (V1) and relief (V2) valves is controlled in such a way that it corresponds to the resonance frequency of the piezoelectric generator (4).

16. System according to any one of claims 14 or 15, wherein the inflow valve (V1) is according to claim 7 and the relief valve (V2) is according to claim 9.

17. Process for accelerating the opening/closing of a valve, said valve comprising a pressurised fluid inlet (E) and a fluid outlet (S), and comprising:
- a fixed plate (P) wherein first fluid flow channels (Rp) are formed,
- a shutter (C) wherein second fluid flow channels (Rc) are formed, said shutter being movably mounted between:
∘ an open position wherein the first channels (Rp) and the second channels (Rc) are in a configuration allowing the flow of the fluid between the inlet (E) and the outlet (S),
∘ a closed position wherein the first channels (Rp) and the second channels (Rc) are in a configuration blocking the flow of the fluid between the inlet (E) and the outlet (S),
- a piezoelectric actuator (A) acting on the shutter (C) to move it between the closed position and the open position, which actuator consists of a piezoelectric pillar formed by a stacking structure of piezoelectric elements, which pillar extends when said actuator is powered and retracts when said actuator is not powered, said process comprising the steps of :
- arranging the inlet (E) in such a way that, in use, the pressurised fluid exerts a pressure force on an active face (Cf1) of the shutter (C) stressing said shutter to the closed position,
- axially prestressing the actuator (A) by means of one or more prestressing rods (At, Tp) forming spring elements in which the restoring force acts in the direction of retraction of the piezoelectric pillar.
